# EUROPEAN PATENT APPLICATION

(11) **EP 1 757 982 A1**
(43) Date of publication of application: **28.02.2007**
(21) Application number: 05743853.3
(22) Date of filing: 24.05.2005
(51) Int. Cl.: G03F 7/033, C08F 2/50, C08F 20/00, G03F 7/00, G03F 7/004, G03F 7/029, G03F 7/038

(54) **NEGATIVE PHOTOSENSITIVE COMPOSITION AND NEGATIVE PHOTOSENSITIVE LITHOGRAPHY PLATE**

(30) Priority: 25.05.2004 JP 2004155270
(71) Applicant: Kodak Polychrome Graphics Japan Ltd., Tokyo 101-0062 (JP)
(72) Inventor: SAKURAI, H., Kodak Polychrome Graphics Japan Ltd., Oura-gun, Gunma 3700723 (JP); HAYAKAWA, E., Kodak Polychrome Graphics Japan Ltd, Oura-gun, Gunma 3700723 (JP)
(74) Representative: Haile, Helen Cynthia
(86) International application number: PCT/JP2005/009453
(87) International publication number: WO 2005/116766

(57) **Abstract**

Disclosed is a negative working photosensitive composition comprising (A) an infrared absorber, (B) an organic boron compound, (C) a compound having a polymerizable unsaturated group, and (D) a binder resin having a sulfonamide or active imino group.

## Description

### TECHNICAL FIELD

The present invention relates to a negative working photosensitive composition and a negative working photosensitive lithographic printing plate used in the field of offset printing and, more particularly, to a negative working photosensitive lithographic printing plate used as a so-called computer-to-plate (CTP) plate capable of directly forming images by irradiation with infrared light, from a solid laser or a semiconductor laser, based on digital signals and to a negative working photosensitive composition suited for use in a photosensitive layer of the lithographic printing plate.
This application claims priority from Japanese Patent Application No. 2004-155270 filed on May 25, 2004, the disclosure of which is incorporated by reference herein.

### BACKGROUND ART

With the progress of computer image processing techniques, a method of directly writing images on a photosensitive layer by light irradiation is response to digital signals, has recently been developed and thus intense interest has been given to a computer-to-plate (CTP) system in which images are directly formed on a photosensitive lithographic printing plate, without being output onto a silver salt mask film, by employing this method. The CTP system, which uses a high-output laser having a maximum intensity in a near-infrared or infrared range, as a light source for light irradiation, has the following advantages: images having high resolution can be obtained by exposure in a short time and the photosensitive lithographic printing plate used in the system can be handled in daylight. Regarding solid and semiconductor lasers capable of emitting infrared light having a wavelength of 760 to 1200 nm, a high-output and portable laser is easily available.

As the negative working photosensitive lithographic printing plate which can form images using a solid laser or a semiconductor laser, a negative working photosensitive lithographic printing plate comprising a photosensitive layer made of a negative working photosensitive composition containing an alkali-soluble resin (for example, novolak resin), a compound which causes crosslinking reaction by an acid (for example, acid crosslinking agent such as resol resin), a compound which generates an acid by heating (acid generator) and a photothermal conversion agent (infrared absorber such as dye or pigment) have been proposed in Japanese Unexamined Patent Publication (Kokai) No. 7-20629 (Patent Document 1).

In the negative working photosensitive lithographic printing plate, negative images are formed by the following procedure. First, when a photosensitive layer is irradiated with infrared light from a solid laser or a semiconductor laser, infrared light is converted into heat by a photothermal conversion agent in the photosensitive layer. An acid is generated from an acid generator due to the heat. Then, when preheating (heating) before developing is conducted, an acid crosslinking agent and an alkali-soluble resin cause a crosslinking reaction by a catalytic action of an acid, or acid crosslinking agents cause a crosslinking reaction, and thus the photosensitive layer exposed to infrared light is made insoluble in an alkali developing solution. Consequently, an image area is formed. However, this negative working photosensitive lithographic printing plate must be preheated before developing, and thus there has been required a negative working photosensitive lithographic printing plate which does not require preheating.

As a negative working photosensitive lithographic printing plate which can form images using a solid laser or a semiconductor laser and also requires no preheating, a negative working photosensitive lithographic printing plate comprising a photosensitive layer made of a negative working photosensitive composition containing a copolymer of allyl methacrylate and methacrylic acid, an ethylenically unsaturated compound, a sensitizing dye and an organic boron salt (photosensitive material 1 of Example 1) has been proposed in Japanese Unexamined Patent Publication (Kokai) No. 2002-244288 (Patent Document 2).

However, this negative working photosensitive lithographic printing plate had a problem that sensitivity deteriorates with the lapse of time after production and, also, the storage stability is poor. Patent Document 1: Japanese Unexamined Patent Publication (Kokai) No. 7-20629
Patent Document 2: Japanese Unexamined Patent Publication (Kokai) No. 2002-244288

### DISCLOSURE OF THE INVENTION

### Problems to be Solved by the Invention

An object of the present invention is to provide a negative working photosensitive composition which is curable by infrared light and is excellent in storage stability, and is also less likely to suffer polymerization inhibition due to oxygen in an air during radical polymerization and forms an image area having high strength, and to provide a negative working photosensitive lithographic printing plate which can directly form images by irradiation with infrared light from a solid laser or a semiconductor laser, based on digital signals, without preheating and is excellent in storage stability, and also shows high sensitivity and is excellent in printing durability.

### Means for Solving the Problems

That is, the negative working photosensitive composition of the present invention comprises:
(A) an infrared absorber,
(B) an organic boron compound,
(C) a compound having a polymerizable unsaturated group, and
(D) a binder resin having a sulfonamide or active imino group.

The binder resin preferably has a phenolic hydroxyl group and, more preferably, has a polymerizable unsaturated group.

The infrared absorber is preferably a near-infrared absorbing cationic dye represented by the following formula (1):

D⁺A⁻ (1)

wherein D⁺ represents a cationic dye having an absorption in a near infrared range, and A⁻ represents an anion.

The organic boron compound is preferably an ammonium salt of a quaternary boron anion represented by the following formula (2):

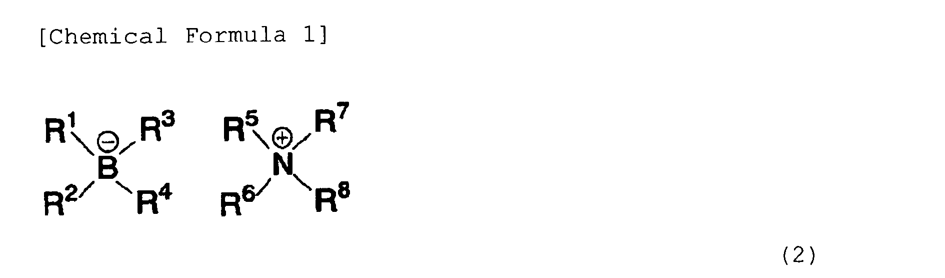

wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

The negative working photosensitive lithographic printing plate of the present invention comprises a substrate and a photosensitive layer containing the negative working photosensitive composition of the present invention formed on the substrate.

### Effect of the Invention

The negative working photosensitive composition of the present invention comprises (A) an infrared absorber, (B) an organic boron compound, (C) a compound having a polymerizable unsaturated group, and (D) a binder resin having a sulfonamide or active imino group, is therefore curable by infrared light, and is excellent in storage stability, and is also less likely to suffer polymerization inhibition due to oxygen during radical polymerization and forms an image area having high strength.

The negative working photosensitive lithographic printing plate of the present invention comprises a substrate, and a photosensitive layer containing the negative working photosensitive composition of the present invention formed on the substrate and therefore can directly form images by irradiation with infrared light from a solid laser or a semiconductor laser, based on digital signals, without preheating and is excellent in storage stability, and also shows high sensitivity and is excellent in printing durability.

### BEST MODE FOR CARRYING OUT THE INVENTION

The present invention will now be described in detail.

### <(A) Infrared absorber>

The infrared absorber (A) in the present invention is a material having a maximum absorption wavelength in a near infrared or infrared range and, for example, a maximum absorption wavelength in a range from 760 nm to 1200 nm. Examples of the material include various pigments or dyes.

The pigments used in the present invention are commercially available dyes described, for example, in "Color Index Handbook, "Latest Pigment Handbook" (edited by Nihon Pigment Technique Society, published in 1977), "Latest Pigment Application Technique" (published by CMC in 1986), and "Printing Ink Technique" (published by CMC in 1984). Applicable types of pigment include black, yellow, orange, brown, red, violet, blue and green pigments, fluorescent pigments and polymer-grafted dyes. For example, there can be used insoluble azo pigments, azo lake pigments, condensed azo pigments, chelated azo pigments, phthalocyanine pigments, anthraquinone pigments, perylene and perinone pigments, thiomindigo pigments, guinacridone pigments, dioxazine pigments, isoindolinone pigments, quinophthalone pigments, lake pigments, azine pigments, nitroso pigments, nitro pigments, natural pigments, fluorescent pigments, inorganic pigments and carbon black.

Among these pigments, carbon black is preferably used as a material which efficiently absorbs light in a near infrared or infrared range and is also economically excellent. As the carbon black, grafted carbon blacks having various functional groups, which are excellent in dispersibility, are commercially available and examples thereof include those described on page 167 of "The Carbon Black, Handbook, 3rd edition" (edited by the Carbon Black Society of Japan and issued in 1995" and those described in page 111 of "Characteristics, Optimum Blending and Applied Technique of Carbon Black" (edited by Technical Information Society in 1997), all of which are preferably used in the present invention.

These pigments may be used without surface treatment, or may be used after surface treatment. As a method of surface treatment, there can be contemplated a method of surface-coating a resin or a wax, a method of attaching a surfactant, and a method of binding a reactive substance (e.g. silane coupling agent, epoxy compound, polyisocyanate etc.) to the surface of a pigment. The above-mentioned surface treating methods are described in "Property and Application of Metal Soap" (Saiwai Shobou), "Printing Ink Technique" (published by CMC in 1984) and "Latest Pigment Application Technique" (published by CMC in 1986). The particle size of these pigments is preferably in a range from 0.01 to 15 µm, and more preferably from 0.01 to 5 µm.

The dyes used in the present invention are conventionally known commercially available dyes described, for example, in "Dye Handbook" (edited by the Association of Organic Synthesis Chemistry, published in 1970), "Handbook of Color Material Engineering" (edited by the Japan Society of Color Material, Asakura Shoten K. K., published in 1989), "Technologies and Markets of Industrial Pigments" (published by CMC in 1983), and "Chemical Handbook, Applied Chemistry Edition" (edited by The Chemical Society of Japan, Maruzen Shoten K. K., published in 1986). Specific examples of the dyes include azo dyes, azo dyes in the form of metal complex salts, pyrazolone azo dyes, anthraquinone dyes, phthalocyanine dyes, carbonium dyes, quinonimine dyes, methine dyes, cyanine dyes, indigo dyes, quinoline dyes, nitro-based dyes, xanthene-based dyes, thiazine-based dyes, azine dyes, and oxazine dyes.

Examples of the dye capable of efficiently absorbing near infrared light or infrared light include cyanine dyes, methine dyes, naphthoquinone dyes, squalirium pigments, arylbenzo(thio)pyridinium salts, trimethinethiapyrylium salts, pyrylium-based compounds, pentamethinethiopyrylium salts and infrared absorbing dyes.

Among these dyes, a near infrared absorbing cationic dye represented by the following general formula (1):

D⁺A⁻ (1)

wherein D⁺ represents a cationic dye having an absorption in a near infrared range and A⁻ represents an anion, is preferable as the infrared absorber (A) because it enables the below-described organic boron compound (B) to efficiently exert a polymerization function.

Examples of the cationic dye having an absorption in a near infrared range include cyanine-based pigments, triarylmethane-based pigments, ammonium-based pigments and diimmonium-based pigments, each having an absorption in a near infrared range. Specific examples of the cationic dye having an absorption in a near infrared range include the followings.

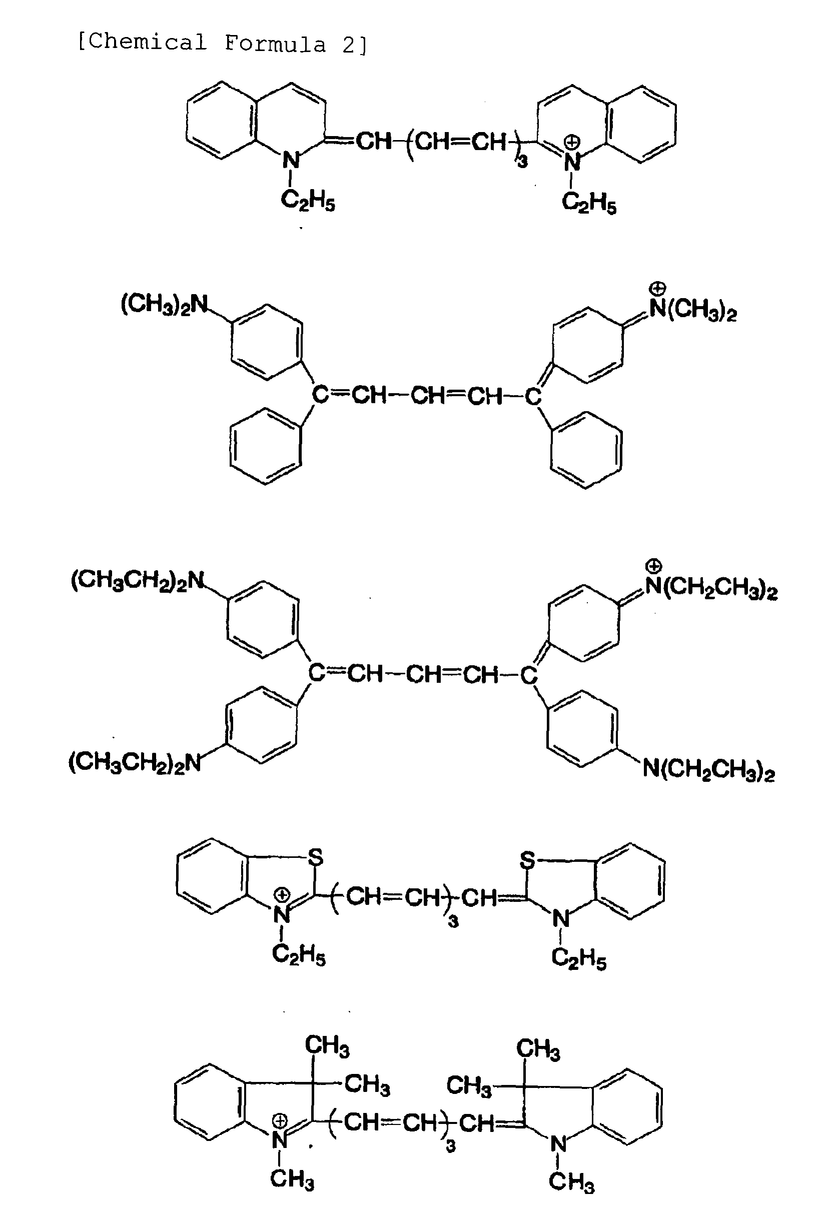

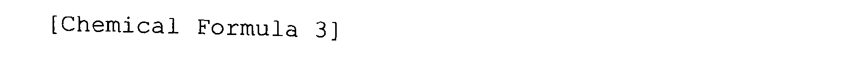

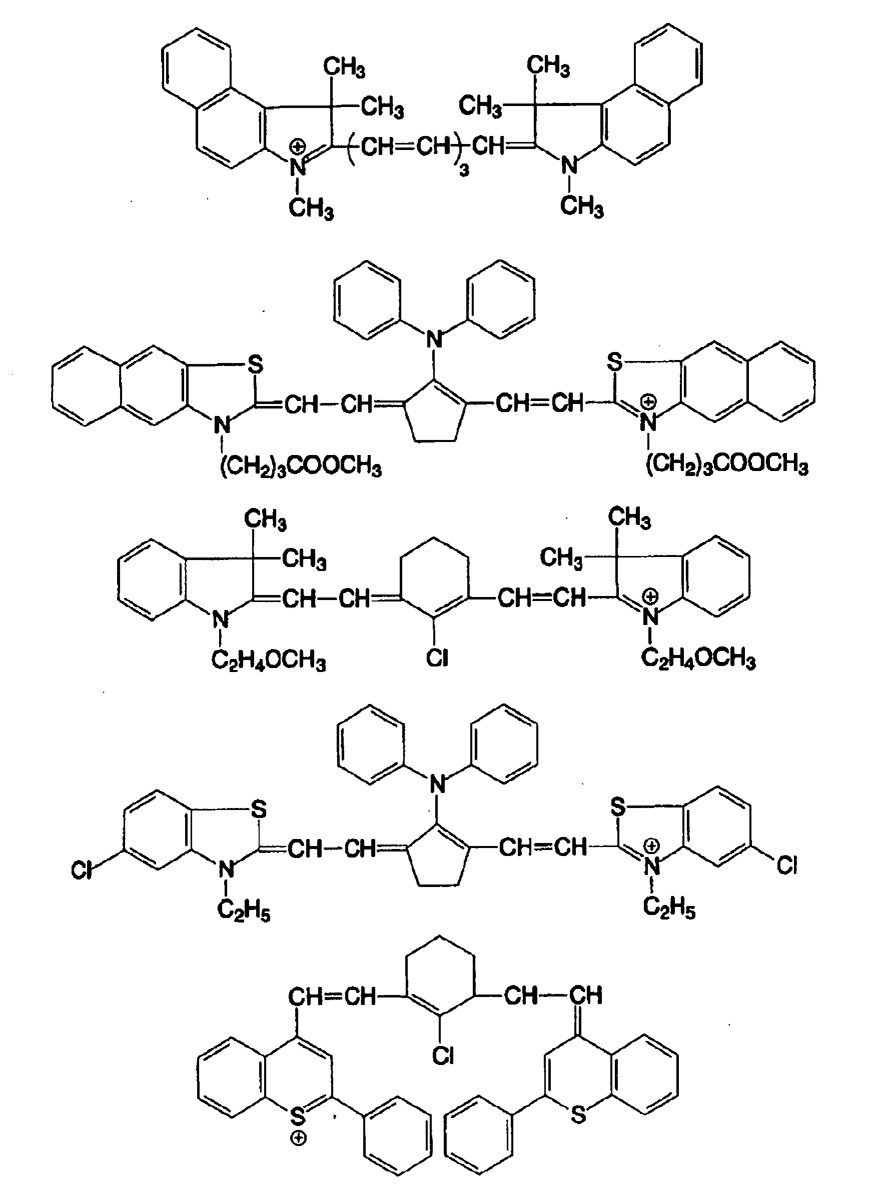

Examples of the anion include halogen anion, ClO₄⁻, PF₆⁻, BF₄⁻, SbF₆⁻, CH₃SO₃⁻, CF₃SO₃⁻, C₆H₅SO₃⁻, CH₃C₆H₄SO₃⁻, HOC₆H₄SO₃⁻, ClC₆H₄SO₃⁻, and a boron anion represented by the following formula:

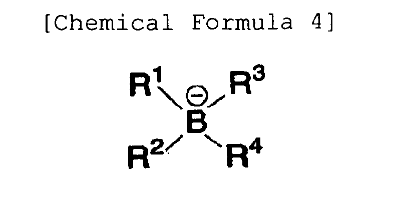

wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, and at last one of R¹, R², R³ and R⁴ is an alkyl group having 1 to 8 carbon atoms. The boron anion is preferably a triphenyl n-butylboron anion or a trinaphthyl n-butylboron anion.

Among cationic dyes having an absorption in a near infrared range, preferred is a dye represented by the following formula:

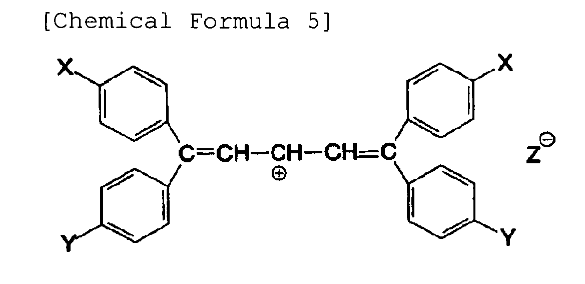

wherein X represents N(C₂H₅)₂ or N(CH₃)₂, Y represents N(C₂H₅)₂, H, or OCH₃, and Z⁻ is an anion represented by the following formula. As these pigments have a maximum absorption wavelength within a range from 817 to 822 nm, the resulting photosensitive lithographic printing plate is suited for an exposure apparatus equipped with an existing near infrared semiconductor laser. As a molar absorption coefficient is 1 × 10⁵ or more, the resulting photosensitive lithographic printing plate is excellent in sensitivity.

Z⁻ of [Chemical Formula 5] is preferably the followings.

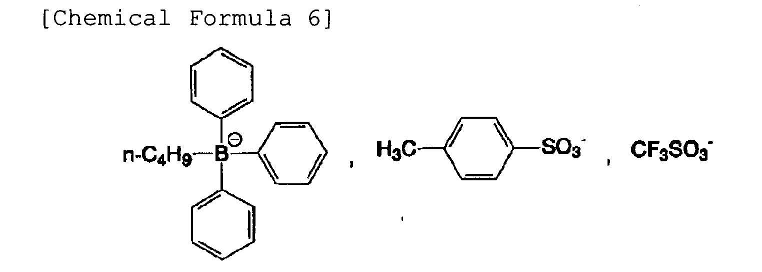

The infrared absorber (A) is used in the following manner. That is, at least one proper pigment or dye capable of absorbing a specific wavelength of a light source described hereinafter is selected from the above pigments or dyes and then added to the negative working photosensitive composition.

When a pigment is used as the infrared absorber (A), the content of the pigment is preferably within a range from 0.5 to 15% by weight, and particularly preferably from 1 to 10% by weight, based on the entire solid content of the negative working photosensitive composition. When the content of the pigment is less than 0.5% by weight, the infrared light is not sufficiently absorbed. On the other hand, when the content of the pigment is more than 15% by weight, an excess of heat tends to be generated, and it is not preferred.

When a dye is used as the infrared absorber (A), the content of the dye is preferably within a range from 0.5 to 15% by weight, and particularly preferably from 1 to 10% by weight, based on the entire solid content of the negative working photosensitive composition. When the content of the dye is less than 0.5% by weight, infrared light is not sufficiently absorbed. On the other hand, when the content of the dye is more than 15% by weight, absorption of infrared light is substantially saturated and the effect of the addition of the dye may not increase, and therefore it is not preferred.

### <(B) Organic boron compound>

The organic boron compound (B) in the present invention exerts a function as a polymerization initiator by using in combination with the above infrared absorber (A). The organic boron compound (B) is preferably an ammonium salt of a quaternary boron anion represented by the following formula (2):

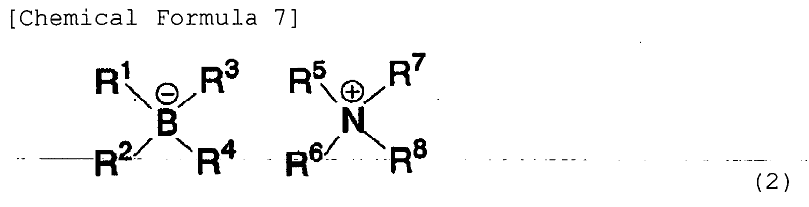

wherein R¹, R², R³ and R⁴ each independently represents an alkyl group, an aryl group, an alkaryl group, an allyl group, an aralkyl group, an alkenyl group, an alkynyl group, an alicyclic group, or saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

Among these, tetra-n-butylammonium triphenylboron, tetra-n-butylammonium trinaphthylboron, tetra-n-butylammonium tri(p-t-butylphenyl)boron, tetramethylammonium n-butyltriphenylboron, tetramethylammonium n-butyltrinaphthylboron, tetramethylammoniumn-octyltriphenylboron, tetramethylammonium n-octyltrinaphthylboron, tetraethylammonium n-butyltriphenylboron, tetraethylammonium n-butyltrinaphthylboron, trimethylhydrogenammonium n-butyltriphenylboron, triethylhydrogenammonium n-butyltriphenylboron, tetrahydrogenammonium n-butyltriphenylboron, tetramethylammonium tetra-n-butylboron and tetraethylammonium tetra-n-butylboron can be preferably used because a polymerization function can be efficiently exerted.

The organic boron compound (B) in the present invention can exert a function as a polymerization initiator by using in combination with the above infrared absorber (A) (for example, D⁺A⁻) in case of generating a radical (R·) by irradiation with infrared light, as shown in the following scheme:

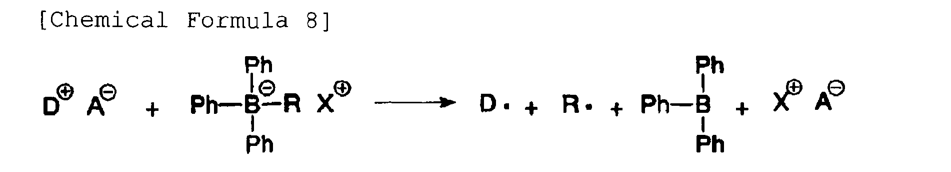

wherein Ph represents a phenyl group, R represents can alkyl group having 1 to 8 carbon atoms, and X⁺ represents an ammonium ion.

The content of the organic boron compound (B) is preferably within a range from 1 to 15% by weight, and particularly preferably from 3 to 10% by weight, based on the solid content of the negative working photosensitive composition. When the content of the organic boron compound (B) is less than 1% by weight, an insufficient polymerization reaction leads to poor curing and the resulting negative working photosensitive lithographic printing plate has weak image area. On the other hand, when the content of the organic boron compound (B) is more than 15% by weight, the polymerization reaction is not efficient. If necessary, at least two organic boron compounds (B) may be used in combination. Also the organic boron compound (B) may be used in combination with known polymerization initiators used in the radical polymerization, such as triazines.

### <(C) Compound having polymerizable unsaturated group>

The compound having a polymerizable unsaturated group (C) in the present invention is a monomer or oligomer which has at least one, preferably at least two addition-polymerizable ethylenically unsaturated groups, and preferably has a boiling point of 100°C or higher at normal pressure.

Examples of the monomer or oligomer monofunctional (meth)acrylates such as polyethylene glycol mono(meth)acrylate [hereinafter, methacrylate ester and acrylate ester are generically referred to as (meth)acrylate ester], polypropylene glycol mono(meth)acrylate, phenoxyethyl(meth)acrylate; polyfunctional (meth)acrylates such as polyethylene glycol di(meth)acrylate, polypropylene glycol di(meth)acrylate, trimethylolpropane tri(meth)acrylate, neopentyl glycol di(meth)acrylate, pentaerythritol tri(meth)acrylate, pentaerythritol tetra(meth)acrylate, dipentaerythritol hexa(meth)acrylate, hexanediol di(meth)acrylate, tri(acryloyloxyethyl) isocyanurate, (meth)acrylate of polyhydric alcohol-alxylene oxide adduct, (meth)acrylate of polyhydric phenol-alkylene oxide adduct, urethane acrylates, polyester acrylates, and epoxy acrylates obtained by an addition reaction of an epoxy resin and (meth)acrylic acid; and polyfunctional allyl compounds such as allyl isocyanurate and allyl cyanurate.

The content of the compound having a polymerizable unsaturated group (D) is preferably within a range from 5 to 60% by weight based on the solid content of the negative working photosensitive composition. When the content of the compound having a polymerizable unsaturated group (D) is less than 5% by weight, insufficient curing occurs. On the other hand, when the content of the compound having a polymerizable unsaturated group (D) is more than 60% by weight, the photosensitive layer of the resulting negative working photosensitive lithographic printing plate is sticky. If necessary, at least two compounds having a polymerizable unsaturated group (D) may be used in combination.

### <(D) Binder resin having sulfonamide or active imino group>

As the binder resin having a sulfonamide or active imino group (D) in the present invention, there can be used a binder resin which has conventionally been used in a negative working photosensitive lithographic printing plate as far as it has a sulfonamide group (-SO₂NH₂) or an active imino group (-SO₂NH- or -CONXCO-; X is described hereinafter). Examples of the binder resin having a sulfonamide or active imino group include a homopolymer comprising a monomer having a sulfonamide or active imino group, or a copolymer obtained by copolymerizing a monomer having a sulfonamide or active imino group with the other polymerizable monomer, of which the copolymer is preferable.

The copolymer is preferably an acrylic copolymer. The acrylic copolymer is a copolymer containing any one of an acrylate ester unit, a methacrylate ester unit, an acrylamide unit and a methacrylamide unit (hereinafter acrylate esters and methacrylate esters are generically referred to as (meth)acrylate esters, and acrylamide and methacrylamide are generically referred to as (meth)acrylamide).

The acrylic copolymer having a sulfonamide or active imino group is not specifically limited as far as it is a copolymer which contains a (meth)acrylate ester unit and/or a (meth)acrylamide unit and also has a sulfonamide or active imino group as an alkali-soluble group.

Examples of the acrylic copolymer having a sulfonamide or active imino group include a copolymer obtained by copolymerizing a (meth)acrylate ester or (meth)acrylamide compound having a sulfonamide group or active imino group or a (meth)acrylate ester or (meth)acrylamide compound having an active imino group with the other monomer which is copolymerizable with the compound.

Examples of the (meth)acrylate ester or (meth)acrylamide compound having a sulfonamide group include those represented by the following formula (1):

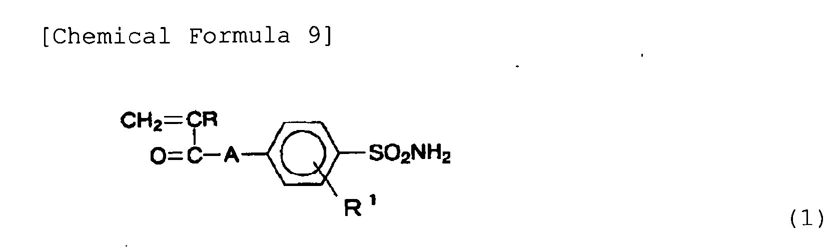

wherein A represents a -O- bond or a -NH- bond, R represents a hydrogen atom or a C₁-C₆ alkyl group, and R¹ represents a hydrogen atom, a C₁-C₆ alkyl group, an aryl group, a halogen or a hydroxyl group.

Examples of the (meth)acrylate ester or (meth)acrylamide compound having an active imino group include those represented by the following formula (2):

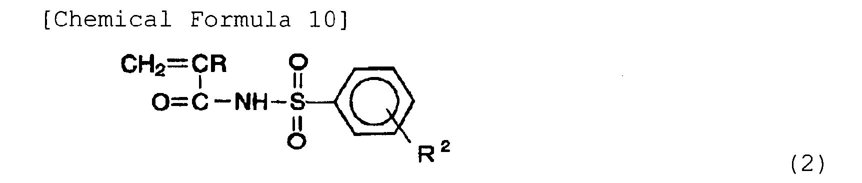

wherein R represents a hydrogen atom or a C₁-C₆ alkyl group, and R² represents a hydrogen atom, a C₁-C₆ alkyl group, an aryl group, a halogen or a hydroxyl group, or the following formula (3):

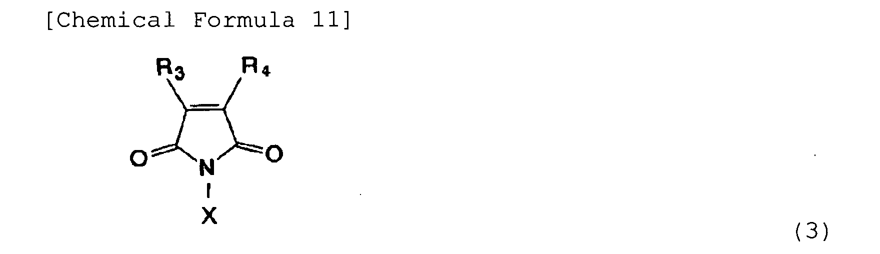

wherein R³ and R⁴ each independently represents a hydrogen atom, a C₁-C₆ alkyl group, an aryl group or a heteroallyl group, and X represents a hydrogen atom, a hydroxyl group or a sulfamoyl group.

Examples of the compound of the formula (1) include m-aminosulfonylphenyl methacrylate, N-(p-aminosulfonylphenyl)methacrylamide and N-(p-aminosulfonylphenyl)acrylamide.

Examples of the compound of the formula (2) include N-(p-toluenesulfonyl)methacrylamide and N-(p-toluenesulfonyl)acrylamide.

Examples of the compound of the formula (3) include maleimide and N-sulfamoylphenylmaleimide.

Specific examples of the other monomer include:
acrylate esters such as methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate and tetrahydroacrylate;
aryl acrylates such as phenyl acrylate and furfuryl acrylate;
methacrylate esters such as methyl methacrylate, ethyl methacrylate, propyl methacrylate, isopropyl methacrylate, allyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate and tetrahydrofurfuryl methacrylate;
aryl methacrylates such as phenyl methacrylate, cresyl methacrylate and naphthyl methacrylate;
N-alkylacrylamides such as N-methylacrylamide, N-ethylacrylamide, N-propylacrylamide, N-butylacrylamide, N-t-butylacrylamide, N-heptylacrylamide, N-octylacrylamide, N-cyclohexylacrylamide and N-benzylacrylamide;
N-arylacrylamides such as N-phenylacrylamide, N-tolylacrylamide, N-nitrophenylacrylamide, N-naphthylacrylamide and N-hydroxyphenylacrylamide; N,N-dialkylacrylamides such as N,N-dimethylacrylamide, N,N-diethylacrylamide, N,N-dibutylacrylamide, N,N-dibutylacrylamide, N,N-diisobutylacrylamide, N,N-diethylhexylacrylamide and N,N-dicyclohexylacrylamide; N,N-arylacrylamides such as N-methyl-N-phenylacrylamide, N-hydroxyethyl-N-methylacrylamide and N-2-acetamideethyl-N-acetylacrylamide;
N-alkylmethacrylamides such as N-methylmethacrylamide, N-ethylmethacrylamide, N-propylmethacrylamide, N-butylmethacrylamide, N-t-butylmethacrylamide, N-ethylhexylmethacrylamide, N-hydroxyethylmethacrylamide and N-cyclohexylmethacrylamide;
N-arylmethacrylamides such as N-phenylmethacrylamide and N-naphthylmethacrylamide;
N,N-dialkylmethacrylamides such as N,N-diethylmethacrylamide, N,N-dipropylmethacrylamide and N,-N-dibutylmethacrylamide;
N,N-diarylmethacrylamides such as N,N-diphenylmethacrylamide;
methacrylamide derivatives such as N-hydroxyethyl-N-methylmethacrylamide, N-methyl-N-phenylmethacrylamide and N-ethyl-N-phenylmethacrylamide;
allyl compounds such as allyl acetate, allyl caproate, allyl caprylate, allyl laurate, allyl palmitate, allyl stearate, allyl benzoate, allyl acetoacetate, allyl lactate and allyloxy ethanol;
vinyl ethers such as hexyl vinyl ether, octyl vinyl ether, dodecyl vinyl ether, ethylhexyl vinyl ether, methoxyethyl vinyl ether, ethoxyethyl vinyl ether, chloroethyl vinyl ether, 1-methyl-2,2-dimethylpropyl vinyl ether, 2-ethylbutyl vinyl ether, hydroxyethyl vinyl ether, diethylene glycol vinyl ether, dimethylaminoethyl vinyl ether, diethylaminoethyl vinyl ether, butylaminoethyl vinyl ether, benzyl vinyl ether, tetrahydrofurfuryl vinyl ether, vinyl phenyl ether, vinyl tolyl ether, vinyl chlorophenyl ether, vinyl-2,4-dichlorophenyl ether, vinyl naphthyl ether and vinyl anthranyl ether;
vinyl esters such as vinyl butyrate, vinyl isobutyrate, vinyl trimethyl acetate, vinyldiethyl acetate, vinyl valeate, vinyl caproate, vinylchloro acetate, vinylmethoxy acetate, vinylbutoxy acetate, vinylphenyl acetate, vinyl acetoacetate, vinyl lactate, vinyl-β-phenyl butyrate, vinylcyclohexyl carboxylate, vinyl benzoate, vinyl salicylate, vinyl chlorobenzoate, vinyl tetrachlorobenzoate and vinyl naphthoate;
styrenes such as styrene, methylstyrene, dimethylstyrene, trimethylstyrene, ethylstyrene, diethylstyrene, isopropylstyrene, butylstyrene, hexylstyrene, cyclohexylstyrene, dodecylstyrene, benzylstyrene, chloromethylstyrene, trifluoromethylstyrene, ethoxymethylstyrene, acetoxymethylstyrene, methoxystyrene, 4-methoxy-3-methylstyrene, dimethoxystyrene, chlorostyrene, dichlorostyrene, trichlorostyrene, tetrachlorostyrene, pentachlorostyrene, bromostyrene, dibromostyrene, iodostyrene, fluorostyrene, 2-bromo-4-trifluoromethylstyrene and 4-fluoro-3-trifluoromethylstyrene;
crotonate esters such as butyl crotonate, hexyl crotonate, crotonic acid and glycerin monocrotonate; dialkyl itaconates such as dimethyl itaconate, diethyl itaconate and dibutyl itaconate;
dialkyls of maleic acid and fumaric acid, such as dimethyl maleate and dibutyl fumarate;
maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide and N-hydroxyphenylmaleimide; and N-vinyl pyrrolidone, N-vinyl pyridine, acrylonitrile and
methacrylonitrile. Among these other monomers, (meth)acrylate esters, (meth)acrylamides, maleimides and (meth)acrylonitriles are preferably used.

In view of alkali solubility, the binder resin having a sulfonamide or active imino group (D) in the present invention preferably has a phenolic hydroxyl group. Such a binder resin can be obtained by copolymerizing a (meth)acrylate ester or a (meth)acrylamide compound having a sulfonamide group or a (meth)acrylate ester or a (meth)acrylamide compound having an active imino group with a (meth)acrylate ester or a (meth)acrylamide compound having a phenolic hydroxyl group.

Examples of the (meth)acrylate ester or the (meth)acrylamide compound having a phenolic hydroxyl group include those represented by the following formula (4):

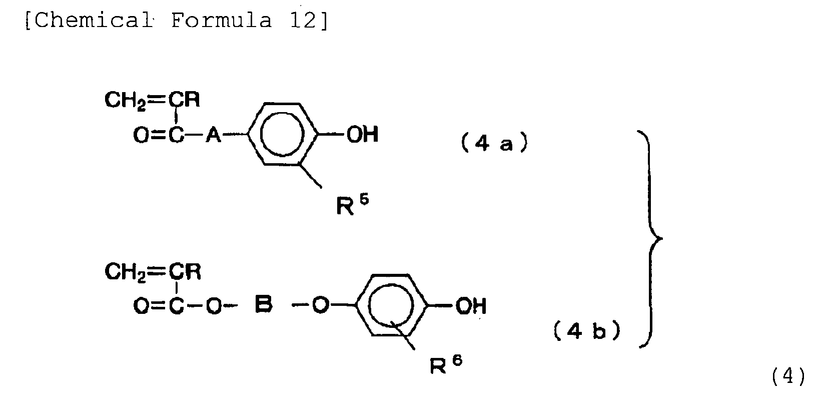

wherein A represents a -O- bond or a -NH- bond, B represents a C₁-C₆ alkylene group, R represents a hydrogen atom or a C₁-C₆ alkyl group, and R⁵ and R⁶ each represents a hydrogen atom, a C₁-C₆ alkyl group, an aryl group, a halogen or a hydroxyl group.

When the binder resin has either a sulfonamide group or a phenolic hydroxyl group, it preferably has a urea bond (-NH-CO-NH-) because of its excellent solvent resistance. Such a binder resin includes, for example, a copolymer obtained by using either of both of (meth)acrylate ester compounds represented by the following formulas (5) and (6)

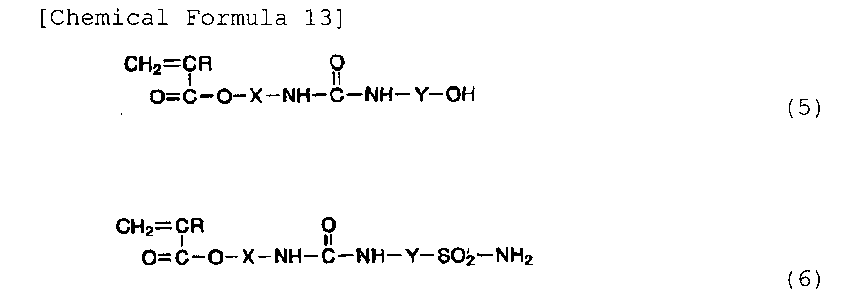

wherein R represents a hydrogen atom or a C₁-C₆ alkyl group, X represents a divalent linking group, and Y represents a divalent aromatic group which may have a substituent, in place of either or both of the compounds of the formulas (1) and (4).

Specific examples of the (meth)acrylate ester compound represented by the formula (5) include acrylate derivatives such as 1-(N'-(4-hydroxyphenyl)ureylene)methylacrylate, 1-(N'-(3-hydroxyphenyl)ureylene)methylacrylate, 1-(N'-(2-hydroxyphenyl)ureylene)methylacrylate, 1-(N'-(3-hydroxy-4-methylphenyl)ureylene)methylacrylate, 1-(N'-(2-hydroxy-5-methylphenyl)ureylene)methylacrylate, 1-(N'-(5-hydroxynaphthyl)ureylene)methylacrylate, 1-(N'-(2-hydroxy-5-phenylphenyl)ureylene)methylacrylate, 2-(N'-(4-hydroxyphenyl)ureylene)ethylacrylate, 2-(N'-(3-hydroxyphenyl)ureylene)ethylacrylate, 2-(N'-(2-hydroxyphenyl)ureylene)ethylacrylate, 2-(N'-(3-hydroxy-4-methylphenyl)ureylene)ethylacrylate, 2-(N'-(2-hydroxy-5-methylphenyl)ureylene)ethylacrylate, 2-(N'-(5-hydroxynaphthyl)ureylene)ethylacrylate, 2-(N'-(2-hydroxy-5-phenylphenyl)ureylene)ethylacrylate, 4-(N'-(4-hydroxyphenyl)ureylene)butylacrylate, 4-(N'-(3-hydroxyphenyl)ureylene)butylacrylate, 4-(N'-(2-hydroxyphenyl)ureylene)butylqacrylate, 4-(N'-(3-hydroxy-4-methylphenyl)ureylene)butylacrylate, 4-(N'-(2-hydroxy-5-methylphenyl)ureylene)butylacrylate, 4-(N'-(5-hydroxynaphthyl)ureylene)butylacrylate and 4-(N'-(2-hydroxy-5-phenylphenyl)ureylene)butylacrylate; and methacrylate derivatives such as 1-(N'-(4-hydroxyphenyl)ureylene)methylmethacrylate, 1-(N'-(3-hydroxyphenyl)ureylene)methylmethacrylate, 1-(N'-(2-hydroxyphenyl)ureylene)methylmethacrylate, 1-(N'-(3-hydroxy-4-methylphenyl)ureylene)methylmethacrylate, 1-(N'-(2-hydroxy-5-methylphenyl)ureylene)methylmethacrylate, 1-(N'-(5-hydroxynaphthyl)ureylene)methylmethacrylate, 1-(N'-(2-hydroxy-5-phenylphenyl)ureylene)methylmethacrylate, 2-(N,-(4-hydroxyphenyl)ureylene)ethylmethacrylate, 2-(N'-(3-hydroxyphenyl)ureylene)ethylmethacrylate, 2-(N'-(2-hydroxyphenyl)ureylene)ethylmethacrylate, 2-(N'-(3-hydroxy-4-methylphenyl)ureylene)ethylmethacrylate, 2-(N'-(2-hydroxy-5-methylphenyl)ureylene)ethylmethacrylate, 2-(N'-(5-hydroxynaphthyl)ureylene)ethylmethacrylate, 2-(N'-(2-hydroxy-5-phenylphenyl)ureylene)ethylmethacrylate, 4-(N'-(4-hydroxyphenyl)ureylene)butylmethacrylate, 4-(N'-(3-hydroxyphenyl)ureylene)butylmethacrylate, 4-(N'-(2-hydroxyphenyl)ureylene)butylmethacrylate, 4-(N'-(3-hydroxy-4-methylphenyl)ureylene)butylmethacrylate, 4-(N'-(2-hydroxy-5-methylphenyl)ureylene)butylmethacrylate, 4-(N'-(5-hydroxynaphthyl)ureylene)butylmethacrylate and 4-(N'-(2-hydroxy-5-phenylphenyl)ureylene)butylmethacrylate. By the way, 2-(N'-(4-hydroxyphenyl)ureylene)ethylmethacrylate has a melting point of 131 to 133°C and can be idenitified from IR spectra attributed to a hydroxyl group and the urea bond.

Specific examples of the (meth)acrylate ester compound represented by the formula (6) include 2-(N'-(4-sulfamoylphenyl)ureylene)ethylacrylate, 2-(N'-(4-sulfamoylphenyl)ureylene)ethylmethacrylate, 2-(N'-(2-hydroxy-5-sulfamoylphenyl)ureylene)ethylmethacrylate and 2-(N'-(2-hydroxy-4-sulfamoylphenyl)ureylene)ethylmethacrylate.

The (meth)acrylate ester compound represented by the formula (5) or (6) can be obtained, for example, by reacting an isocyanate compound represented by the following formula (7) with an amine compound represented by the following formula (8) (in the formula, R represents a hydrogen atom or a methyl group, R' represents a hydrogen atom, or an alkyl group which may have a substituent, X represents a divalent linking group, Y represents a divalent aromatic group which may have a substituent, and Z represents a hydroxyl group or a sulfonamide group.

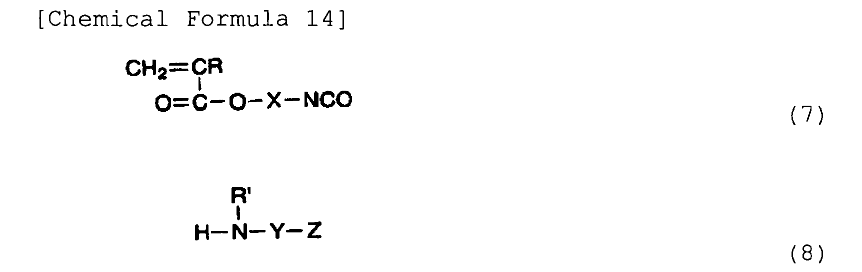

Examples of the isocyanate compound represented by the formula (7) include methacryloyloxyethyl isocyanate and acryloyloxyethyl isocyanate, and examples of the amine compound represented by the formula (8) include 4-aminophenol, 3-aminophenol, 2-aminophenol, 4-aminosalicylic acid, 2-aminophenol-4-sulfonamide, 4-aminobenzenesulfonamide and 4-amino-6-chloro-1,3-benzenedisulfonamide.

When the binder resin having a sulfonamide or active imino group in the present invention comprises an acrylic copolymer, it preferably contains 10 to 80% by weight of the (meth)acrylate ester compound or (meth)acrylamide compound unit of the formulas (1) to (6). When the content of the (meth)acrylate ester compound unit represented by the formulas (1) to (6) is less than 10% by weight, solvent resistance and alkali solubility may deteriorate. On the other hand, when the content is more than 80% by weight, it is possible that it will be impossible to dissolve it in a solvent used in case of coating and also the image area is corroded during development.

The molecular weight of the binder resin having a ulfonamide or active imino group in the present invention is preferably 2,000 or more and the number average molecular weight is preferably 1,000 or more. More preferably, the weight average molecular weight is within a range from 3,000 to 500,000 and the number average molecular weight is within a range from 2,000 to 400,000.

The binder resin having a sulfonamide or active imino group (D) preferably has a polymerizable unsaturated group such as acryloyl group, methacryloyl group or allyl group in the side chain. The binder resin having a sulfonamide or active imino group (D) which has an allyl group in the side chain can be obtained, for example, by copolymerizing a (meth)acrylate ester or (meth)acrylamide compound represented by the formulas (1) to (6) with an allyl (meth)acrylate ester compound such as allyl methacrylate and/or allyl acrylate. As such a binder resin causes the crosslinking reaction with a compound having a polymerizable unsaturated group (C) and crosslink density increases, the printing durability of the resulting photosensitive lithographic printing plate is improved.

The content of the binder resin having a sulfonamide or active imino group (D) is preferably within a range from 20 to 70% by weight based on the solid content of the negative working photosensitive composition. When the content of the binder resin having a sulfonamide or active imino group (D) is less than 20% by weight, the resulting negative working photosensitive lithographic printing plate has a weak image area because of insufficient curing. On the other hand, when the content of the binder resin having a sulfonamide or active imino group (D) is more than 70% by weight, the efficiency of the curing reaction is low. If necessary, two or more kinds of binder resins having a sulfonamide or active imino group (D) may be used in combination.

### <Onium salt>

The negative working photosensitive composition of the present invention can be mixed with an onium salt. The onium salt is a salt comprising a cation having at least one onium ion atom in the molecule, and an anion. Examples of the onium ion atom in the onium salt include S⁺ atom in sulfonium, I⁺ atom in iodonium, N⁺ in ammonium, and P⁺ atom in phosphonium (excluding a diazonium compound such as diazo resin). Among these onium ion atoms, S⁺ and I⁺ atoms are preferable.

Examples of the anion of the onium salt include halogen anion, ClO₄⁻, PF₆⁻, BF₄⁻, SbF₆⁻, CH₃SO₃⁻, CF₃SO₃⁻, C₆H₅SO₃⁻, CH₃C₆H₄SO₃⁻, HOC₆H₄SO₃⁻, ClC₆H₄SO₃⁻, and a boron anion represented by [Chemical Formula (4)].

The onium salt is preferably obtained by combining an onium salt having S⁺ in the molecule with an onium salt having I⁺ in the molecule in view of sensitivity and storage stability. In view of sensitivity and storage stability, the onium salt (C) is preferably a polyhydric onium salt having at least two onium ion atoms in the molecule. At least two onium ion atoms in the cation are bonded through a covalent bond. Among polyhydric onium salts, those having at least two onium ion atoms in the molecule are preferable and those having S⁺ and I⁺ in the molecule are particularly preferable. Particularly preferable polyhydriconium salts are represented by the following formulas:

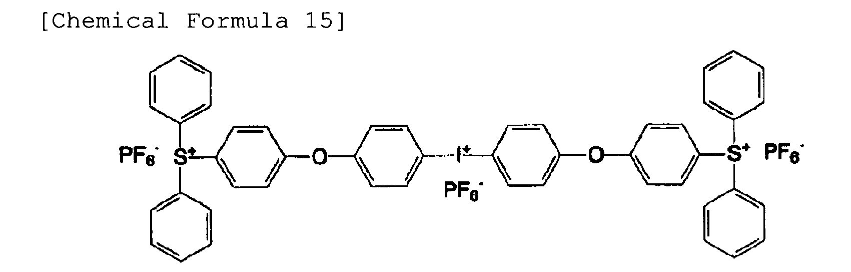

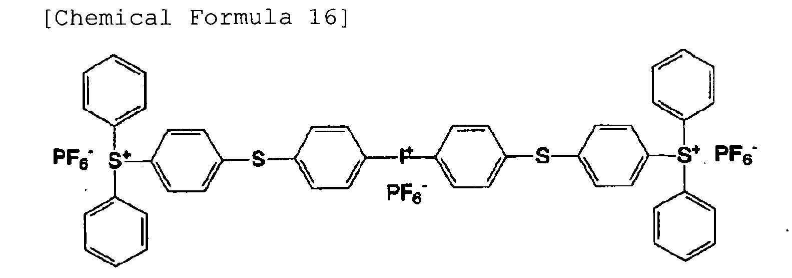

The content of the onium salt is preferably within a range from 2 to 30% by weight, and particularly preferably from 5 to 20% by weight, based on the solid content of the negative working photosensitive composition. When the content of the onium salt is less than 2% by weight, the resulting negative working photosensitive lithographic printing plate may be insufficient in sensitivity and printing durability because of insufficient polymerization reaction. On the other hand, when the content of the onium salt is more than 30% by weight, the resulting negative working photosensitive lithographic printing plate is inferior in developing properties. If necessary, at least two onium salts may be used in combination. Also the polyhydric onium salt may be used in combination with the onium salt.

### <Negative working photosensitive composition>

To the negative working photosensitive composition of the present invention, known additives such as colorants (dyes, pigment), surfactants, plasticizers, stability modifiers, polymerization inhibitors and lubricants (silicon powders) can be added, if necessary.

Examples of preferable dyes include basic oil-soluble dyes such as Crystal Violet, Malachite Green, Victoria Blue, Methylene Blue, Ethyl Violet and Rhodamine B. Examples of the commercially available dye include "Victoria Pure Blue BOH" [manufactured by HODOGAYA CHEMICAL Co., Ltd.], "Oil Blue #603" [manufactured by Orient Chemical Industries, LTD.], "VPB-Naps (naphthalene sulfonate of Victoria Pure Blue)" [manufactured by HODOGAYA CHEMICAL Co., Ltd.] and "D11" [manufactured by PCAS Co.]. Examples of the pigment include Phthalocyanine Blue, Phthalocyanine Green, Dioxadine Violet and Quinacridone Red.

Examples of the surfactant include fluorine-based surfactants and silicone-based surfactants.

Examples of the plasticizer include diethyl phthalate, dibutyl phthalate, dioctyl phthalate, tributyl phosphate, trioctyl phosphate, tricresyl phosphate, tri(2-chloroethyl) phosphate and tributyl citrate.

As the known stability modifier, for example, phosphoric acid, phosphorous acid, oxalic acid, tartaric acid, malic acid, citric acid, dipicolinic acid, polyacrylic acid, benzenesulfonic acid and toluenesulfonic acid can be used in combination.

Examples of the polymerization inhibitor include known phenolic compound, quinones, N-oxide compound, amine-based compound, sulfide group-containing compound, nitro group-containing compound and transition metal compound. Specific examples thereof include hydroquinone, p-methoxyphenol, p-cresol, pyrogallol, t-butylcatechol, benzoquinone, 4,4'-thiobis(3-methyl-6-t-butylphenol), 2,2'-methylenebis(4-methyl-6-t-butylphenol), 2-mercaptobenzimidazole and N-nitrosophenylhydroxyamine primary cerium salt.

The contents of these various additives vary depending on the purposes, but are preferably within a range from 0 to 30% by weight based on the solid content of the photosensitive composition.

The negative working photosensitive composition of the present invention may contain higher fatty acids such as stearic acid, behenic acid amide or methyl behenate. When the negative working photosensitive composition of the present invention is applied to the substrate and dried to form a photosensitive layer, higher fatty acids ooze out on the surface of the photosensitive layer thereby to coat the surface of the photosensitive layer, and thus penetration of oxygen from the air, which inhibits the polymerization reaction in the photosensitive layer, and penetration of a low-molecular compound such as basic substance into the photosensitive layer, are prevented. Also, the higher fatty acid exerts effects such as prevention of scratching of the surface of the photosensitive layer, joined paper releasability and blocking resistance.

For the purpose of improving printing durability of the resulting negative working photosensitive lithographic printing plate, the negative working photosensitive composition of the present invention may contain sensitizers such as hexaarylbiimidazoles and ketocoumarines; cyanine-based sensitizing dye cation having a structure in which a heterocycle is attached via a polymethine chain and/or a phthalocyanine-based sensitizing dye.

In the above-described negative working photosensitive composition, as the infrared absorber (A) is used in combination with the organic boron compound (B) which exerts a function as a polymerization initiator, when used in combination with the infrared absorber, the polymerization of the compound having a polymerizable unsaturated group (C) proceeds under infrared light. Therefore, this negative working photosensitive composition is curable with infrared light.

Although the reason is not clear, by using the organic boron compound (B) as the polymerization initiator, polymerization inhibition due to oxygen is less likely to occur during the radical polymerization.

Storage stability of the composition is improved by using it in combination with the binder resin having a sulfonamide or active imino group (D).

As described above, by using the negative working photosensitive composition containing the organic boron compound (B), which causes less polymerization inhibition due to oxygen during the radical polymerization, and the binder resin having a sulfonamide or active imino group (D), as the photosensitive layer of the negative working photosensitive lithographic printing plate, it becomes possible to obtain a negative working photosensitive lithographic printing plate which shows high sensitivity and is excellent in printing durability and storage stability.

Although the reason is not clear, the use of the onium salt accelerates the radical polymerization initiated by using the infrared absorber (A) in combination with the organic boron compound (B). Also, the storage stability of the negative working photosensitive composition is improved. Such an operation and effect is not exerted if the organic boron compound (B) and the onium salt are not used in combination, and is not exerted if the boron compound (B) is not used and the onium salt is used alone as the polymerization initiator.

### <Negative working photosensitive lithographic printing plate>

The negative working photosensitive lithographic printing plate of the present invention is schematically composed of a substrate and a photosensitive layer made of the negative working photosensitive composition formed on the substrate.

Examples of the substrate include metal plates such as aluminum, zinc, copper, stainless steel, and iron plates; plastic films such as polyethylene terephthalate, polycarbonate, polyvinyl acetal, and polyethylene films; composite materials obtained by vacuum-depositing or laminating a metal layer on paper or a plastic film on which a synthetic resin is melt-coated or a synthetic resin solution is coated; and materials used as the substrate of the printing plate. Among these substrates, aluminum and composite substrates coated with aluminum are preferably used.

The surface of the aluminum substrate is preferably subjected to a surface treatment for the purpose of enhancing water retention and improving adhesion with the photosensitive layer. Examples of the surface treatment include surface roughening treatments such as brush polishing, ball polishing, electrolytic etching, chemical polishing, liquid honing, sand blasting, and a combination thereof. Among these surface treatments, a surface roughening treatment including the use of electrolytic etching is preferable.

As the electrolytic bath used in the electrolytic etching, an aqueous solution containing acid, alkali or a salt thereof, or an aqueous solution containing an organic solvent is used. Among these, an electrolytic solution containing hydrochloric acid, nitric acid, or a salt thereof is preferable.

The aluminum plate subjected to the surface roughening treatment is subjected to desmutting using an aqueous solution of an acid or alkali, if necessary. The aluminum substrate thus obtained is preferably subjected to an anodizing treatment. An anodizing treatment of treating using a bath containing sulfuric acid or phosphoric acid is particularly preferable.

If necessary, it is possible to conduct a silicate treatment (sodium silicate, potassium silicate), a potassium fluorozirconate treatment, a phosphomolybdate treatment, an alkyl titanate treatment, a polyacrylic acid treatment, a polyvinylsulfonic acid treatment, a polyvinylphosphonic acid treatment, a phytic acid treatment, treatment with a salt of a hydrophilic organic polymer compound and a divalent metal, a hydrophilization treatment by undercoating with a water soluble polymer having an sulfonic acid group, a coloring treatment with an acidic dye, and electrodeposition with a silicate.

The aluminum substrate is preferably subjected to a sealing treatment after being subject to the surface roughening treatment (graining treatment) and the anodizing treatment. The sealing treatment can be conducted by dipping an aluminum substrate in hot water or a hot water solution containing an inorganic or organic salt, or by using a steam bath.

The negative working photosensitive lithographic printing plate of the present invention is produced by applying a solution or a dispersion, which is prepared by dissolving or dispersing a negative working photosensitive composition in an organic solvent, on the surface of a substrate, followed by drying to form a photosensitive layer on the substrate.

As an organic solvent in which the negative working photosensitive composition is dissolved or dispersed, for example, any conventionally known organic solvent can be used. Regarding this organic solvent, are having a boiling point within a range from 40 to 200°C, particularly from 60 to 160°C, is selected because it is advantageous in case of drying.

Examples of the organic solvent include alcohols such as methyl alcohol, ethyl alcohol, n- or iso-propyl alcohol, n- or iso-butyl alcohol and diacetone alcohol; ketones such as acetone, methyl ethyl ketone, methyl propyl ketone, methyl butyl ketone, methyl amyl ketone, methyl hexyl ketone, diethyl ketone, diisobutyl ketone, cyclohexanone, methylcyclohexanone and acetylacetone; hydrocarbons such as hexane, cyclohexane, heptane, octane, nonane, decane, benzene, toluene, xylene and methoxybenzene; acetate esters such as ethyl acetate, n- or iso-propyl acetate, n- or iso-butyl acetate, ethylbutyl acetate and hexyl acetate; halides such as methylene dichloride, ethylene dichloride and monochloorbenzene; ethers such as isopropyl ether, n-butyl ether, dioxane, dimethyldioxane and tetrahydrofuran; polyhydric alcohols and derivatives thereof, such as ethylene glycol, ethylene glycol monomethyl ether, ethylene glycol monomethyl ether acetate, ethylene glycol monoethyl ether, ethylene glycol monoethyl ether acetate, ethylene glycol monobutyl ether, ethylene glycol monobutyl ether acetate, ethylene glycol dimethyl ether, ethylene glycol diethyl ether, ethylene glycol dibutyl ether, methoxyethoxy ethanol, diethylene glycol monomethyl ether, diethylene glycol dimethyl ether, diethylene glycol methylethyl ether, diethylene glycol diethyl ether, propylene glycol, propylene glycol monomethyl ether, propylene glycol monomethyl ether acetate, propylene glycol monoethyl ether, propylene glycol monoethyl ether acetate, propylene glycol monobutyl ether, 3-methyl-3-methoxybutanol and 1-methoxy-2-propanol; and special solvents such as dimethyl sulfoxide, N,N-dimethylformamide, methyl lactate and ethyl lactate. These organic solvents can be used alone or in combination. The solid content in the negative working photosensitive composition to be applied is preferably adjusted within a range from 2 to 50% by weight. The solid content as used herein means a component other than the organic solvent.

As the method of coating a negative working photosensitive composition, for example, there can be used roll coating, dip coating, air knife coating, gravure coating, gravure offset coating, hopper coating, blade coating, wire doctor coating, and spray coating methods. The coating weight of the negative working photosensitive composition is preferably within a range from 10 to 100 ml/m².

The negative working photosensitive composition applied on the substrate is usually dried by heated air. The drying temperature (temperature of the heated air) is preferably within a range from 30 to 200°C, and particularly preferably from 40 to 140°C. Not only a method of maintaining the drying temperature at a fixed temperature, but also a method of stepwisely raising the drying temperature can be employed.

Preferred results can sometimes be obtained by dehumidifying the air. The heated air is preferably blown against the surface to be coated at a rate within a range from 0.1 to 30 m/second, and particularly preferably from 0.5 to 20 m/second.

The coating weight of the negative working photosensitive composition is usually within a range from about 0.5 to about 5 g/m², in terms of a dry weight.

In the negative working photosensitive lithographic printing plate of the present invention, a protective layer can be formed on the photosensitive layer so as to conduct laser irradiation in the air. The protective layer prevents penetration of oxygen from the air, which inhibits the polymerization reaction in the photosensitive layer, and penetration of a low-molecular compound such as basic substance into the photosensitive layer, and enables laser irradiation in an air. Therefore, the characteristics required of the protective layer include low permeability to a low-molecular compound such as oxygen, and good permeability of light used for exposure, excellent adhesion with the photosensitive layer and easy removal during a developing treatment after laser irradiation.

As the material of the protective layer, for example, a water-soluble polymer compound having comparatively excellent crystallinity can be used, and specific examples thereof include water-soluble polymer such as polyvinyl alcohol, polyvinyl pyrrolidone, acidic celluloses, gelatin, gum arabic or polyacrylic acid. The use of polyvinyl alcohol, among these polymers, as a main component gives good results to basic characteristics such as an oxygen screening property and a development eliminating property. Polyvinyl alcohol used in the protective layer may be partially substituted with an ester, an ether and an acetal as far as it contains an unsubstituted vinyl alcohol unit for imparting the required oxygen screening properties and water solubility. Similarly, a portion of polyvinyl alcohol contains the other copolymer component.

Specific examples of polyvinyl alcohol (PVA) include those having a hydrolysis rate of 71 to 100% and a molecular weight within a range from 300 to 2400. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, which are manufactured by Kuraray Co., Ltd.

Components of the protective layer (selection of PVA, use of additives) and the coating weight are selected taking account of fog resistance, adhesion and scratch resistance, in addition to oxygen screening properties and a development eliminating property. The higher the hydrolysis rate of the PVA to be used (the higher the content of an unsubstituted vinyl alcohol unit in the protective layer), the larger the thickness, the more the oxygen screening properties are enhanced, and thus it is advantageous in view of sensitivity. However, when oxygen screening properties are extremely enhanced, there arise problems that an undesired polymerization reaction occurs during the production and storage and undesired fog and line pattern thickening occur during laser irradiation. Also adhesion of the image area and scratch resistance are very important in view of handling of the plate. That is, when a hydrophilic layer made of a water-soluble polymer is laminated on a hydrophilic polymer layer, film peeling due to poor adhesive force is likely to occur and the peeled portion causes defects such as poor film curing due to the polymerization inhibition by oxygen. The method of improving adhesion between two layers includes a method of mixing a hydrophilic polymer composed mainly of polyvinyl alcohol with 20 to 60% by weight of am acrylic emulsion or a water-soluble vinyl pyrrolidone-vinyl acetate copolymer.

In the negative working photosensitive lithographic printing plate of the present invention, the photosensitive layer or the protective layer may contain a matting agent or a matte layer may be formed on the photosensitive layer or the protective layer for the purpose of improving the joined paper releasability and the plate carrying properties of an automatic plate feeder.

The negative working photosensitive lithographic printing plate of the present invention can be used in a so-called computer-to-plate (CTP) system which can directly write images on a plate, using a laser, based on digital image information from a computer.

As a light-source laser in the present invention, a high-output laser having a maximum intensity within the near-infrared or infrared range is most preferably used because the negative working photosensitive lithographic printing plate can be processed in daylight. Examples of a high-output laser having a maximum intensity within a near-infrared or infrared range include various lasers having a maximum intensity within a near-infrared or infrared range of 760 to 1200 nm and, for example, a semiconductor laser and a YAG laser.

The lithographic printing plate precursor of the present invention is converted into a lithographic printing plate having the image area formed thereon by writing images on the photosensitive layer using laser, followed by a development treatment and removal of the non-image area using a wet method. In the present invention, a developing treatment may be conducted immediately after laser irradiation, and a heat-treating step can be provided between a laser irradiation step and a developing step. The heat treatment is preferably conducted under the conditions of a temperature within a range from 80 to 150°C for 10 seconds to 5 minutes. This heat treatment can reduce the laser energy required for writing images during laser irradiation. The developing solution used in the developing treatment includes, for example, an aqueous alkali solution (aqueous basic solution).

Examples of the alkali agent used in the developing solution include inorganic alkali compounds such as sodium silicate, potassium silicate, potassium hydroxide, sodium hydroxide, lithium hydroxide, sodium, potassium or ammonium salts of secondary or tertiary phosphoric acid, sodium metasilicate, sodium carbonate, and ammonia; and organic alkali compounds such as monomethylamine, dimethylamine, trimethylamide, monoethylamine, diethylamine, triethylamine, monoisopropylamine, diisopropylamine, triisopropylamine, n-butylamine, di-n-butylamine, monoethanolamine, diethanolamine, triethanolamine, ethyleneimine, and ethylenediamine.

The content of the alkali agent in the developing solution is preferably within a range from 0.005 to 10% by weight, and particularly preferably from 0.05 to 5% by weight. The content of the alkali agent in the developing solution of less than 0.005% by weight is not preferable because the development may not be conducted sufficiently. The content of more than 10% by weight is not preferable because an adverse influence such as corrosion of the image area is exerted on development.

An organic solvent can also be added to the developing solution. Examples of the organic solvent, which can be added to the developing solution, include ethyl acetate, butyl acetate, amyl acetate, benzyl acetate, ethylene glycol monobutyl acetate, butyl lactate, butyl levulinate, methyl ethyl ketone, ethyl butyl ketone, methyl isobutyl ketone, cyclohexanone, ethylene glycol monobutyl ether, ethylene glycol monobenzyl ether, ethylene glycol monophenyl ether, benzyl alcohol, methylphenyl carbitol, n-amyl alcohol, methylamyl alcohol, xylene, methylene dichloride, ethylene dichloride, and monochlorobenzene. When the organic solvent is added to the developing solution, the content of the organic solvent is preferably 20% by weight or less, and particularly preferably 10% by weight or less.

If necessary, it is also possible to add, in the developing solution, water soluble sulfites such as lithium sulfite, sodium sulfite, potassium sulfite, and magnesium sulfite; hydroxyaromatic compounds such as alkali-soluble pyrazolone compound, alkali-soluble thiol compound, and methyl resorcin; water softeners such as polyphosphate and aminopolycarboxylic acids; various surfactants, for example, anionic, cationic, amphoteric and fluorine-based surfactants such as sodium isopropylnaphthalenesulfonate, sodium n-butylnaphthalenesulfonate, sodium N-methyl-N-pentadecylaminoacetate, and sodium lauryl sulfate; and various defoamers.

As the developing solution, commercially available developing solutions for negative or positive working type PS plate can be used. Specifically, a solution prepared by diluting a commercially available concentrated developing solution for negative or positive working type PS plate 1 to 1000 times can be used as the developing solution in the present invention.

The temperature of the developing solution is preferably within a range from 15 to 40°C, and the dipping time is preferably within a range from 1 second to 2 minutes. If necessary, the surface can be slightly rubbed during the development.

After the completion of the development treatment, the lithographic printing plate is washed with water and/or subjected to a treatment with an aqueous desensitizing agent (finishing gum). Examples of the aqueous desensitizing agent include aqueous solutions of water soluble natural polymers such as gum arabic, dextrin, and carboxymethyl cellulose, and aqueous solutions of water soluble synthetic polymers such as polyvinyl alcohol, polyvinyl pyrrolidone, and polyacrylic acid. If necessary, acids or surfactants are added to these aqueous desensitizing agents. After being subjected to a treatment with the desensitizing agent, the lithographic printing plate is dried and then used for printing as a printing plate.

For the purpose of improving printing durability of the resulting lithographic printing plate, the lithographic printing plate can be subjected to a burning treatment or an post exposure treatment after the developing treatment.

The burning treatment is conducted by the steps of (i) washing the lithopgraphic printing plate obtained by the above-descried treating method with water and removing a rinsing solution or a gum solution, followed by squeegeeing, (ii) uniformly spreading a counter-etching solution over the plate, followed by drying, (iii) burning the plate in an oven under the temperature conditions within a range from 180 to 300°C for 1 to 30 minutes, and (iv) washing the cooled plate with water to remove the counter-etching solution, followed by gum coating and further drying.

The post exposure treatment is conducted by subjecting the surface of the image area side of the lithographic printing plate to entire surface exposure after the developing treatment. The post exposure treatment is preferably conducted by entire-surface post-exposure at an exposure energy that is not more than 50 times of that in case of laser irradiation, preferably 1 to 30 times as that in case of laser irradiation, and more preferably 2 to 15 times as that in case of laser irradiation. When exposure energy upon post exposure is 50 times larger than that in case of the laser irradiation, sufficient printing durability may not be obtained. The exposure energy of laser irradiation is not specifically limited as far as it satisfies the above relation with exposure energy upon laser irradiation, and is preferably adjusted within a range from 10 mJ/cm² to 10 J/cm², and more preferably from 50 mJ/cm² to 8 J/cm², in view of the relation to the treating time.

The light source for post exposure is not specifically limited and examples thereof include carbon arc, high-pressure mercury lamp, ultrahigh-pressure air gun mercury lamp, low-pressure mercury lamp, deep UV lamp, xenon lamp, metal halide lamp, fluorescent lamp, tungsten lamp, halogen lamp and excimer laser lamp. Among these, a mercury lamp and a metal halide lamp is preferable and a mercury lamp is particularly preferable.

The post exposure treatment may be conducted in a state where the lithographic printing plate is at rest, or may be conducted while continuously transferring the lithographic printing plate. In view of the strength of the image area, the light intensity on the surface of the lithographic printing plate is preferably adjusted within a range from 20 mW/cm² to 1 W/cm², and more preferably from 30 mW/cm² to 500 W/cm². To adjust the light intensity on the surface of the lithographic printing plate within the above range, the output of the light source to be used is increased. In case of a bar type light source, an output (W) of the light source is increased by increasing an output per unit length. Alternatively, exposure is conducted after bringing the surface of the lithographic printing plate close to the light source. Upon post exposure, the temperature of the surface of the lithographic printing plate is preferably adjusted within a range from 40 to 300°C, and more preferably from 50 to 200°C, by heating using heating means such as radiation heat from a light source for post exposure, a hot plate, a dryer or a ceramic heater. The heating means is preferably radiation heat from a light source because it is simple.

In the negative working photosensitive lithographic printing plate as described above, a negative working photosensitive composition, which is less likely to cause polymerization inhibition due to oxygen during radical polymerization and is excellent in storage stability, is used as a photosensitive layer. Thus, the resulting negative working photosensitive lithographic printing plate shows high sensitivity and is excellent in printing durability and storage stability. The negative working photosensitive composition of the present invention can be used for various purposes such as a photoresist and a color filter, in addition to use as a lithographic printing plate.

### EXAMPLES

The present invention will now be described in detail by way of examples, but the present invention is not limited to the scope of the following examples.

### (Synthesis of 2-(N'-(2-hydroxy-5-sulfamoylphenyl)ureylene)ethylmethacrylate)

In a 1 liter four-necked flask equipped with a thermometer, a condenser tube, a stirrer and a dropping tube, 500 g of dimethylacetamide and 225.6 g (1.2 mol) of 2-aminophenol-4-sulfonamide were charged. Under ice cooling, 172.3 g (1.1 mol) of 2-methacryloyloxyethyl isocyanate (manufactured by SHOWA DENKO K.K. under the trade name of Karenz MOI) was added dropwise over one hour. After the completion of dropwise addition, the reaction temperature was returned to room temperature, followed by continuous stirring for 5 hours. The IR spectrum was measured and confirmed that adsorption of isocyanate was minimized. Then, 20 ml of concentrated hydrochloric acid was added to the reaction solution, followed by stirring for 15 minutes. The reaction solution was poured into 4.5 liter of water thereby to precipitate the reaction product. The precipitate was filtered, washed with water and then dried at 30°C under reduced pressure to obtain 356 g 2-(N'-(2-hydroxy-5-sulfamoylphenyl)ureylene)ethylmethacrylate (yield: 94.5%).

### (Synthesis of binder D1)

In a 300 ml three-necked flask equipped with a capacitor and a stirrer, 100.00 g of dimethylacetamide was charged and, after the atmosphere in the flask was replaced by nitrogen, the liquid temperature was raised to 80°C. To this was added dropwise a solution prepared by dissolving 13.00 g of allyl methacrylate, 7.00 g of 2-(N'-(2-hydroxy-5-sulfamoylphenyl)ureylene)ethylmethacrylate and 0.40 g of 2,2'-azobisisobutyronitrile in 80.00 g of dimethylacetamide over 2 hours. One hour after the completion of dropwise addition, 0.20 g of 2,2'-azobisisobutyronitrile was added again, followed by heating for 5 hours. The reaction solution was poured into 1 liter of water while stirring thereby to precipitate a yellowish white polymer. The polymer was washed with water and vacuum dried to obtain 19.00 g of a binder resin D1 of the following formula. Yield was 95% by weight.

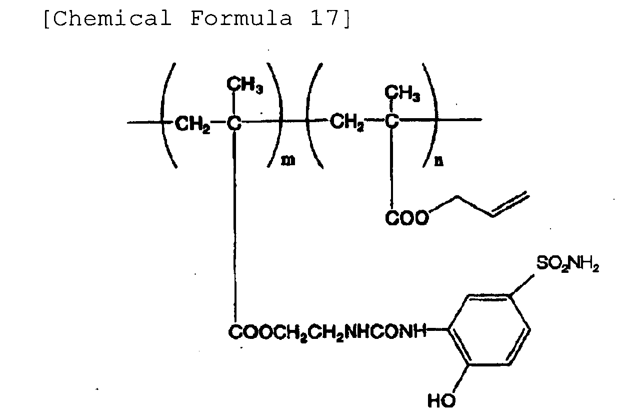

### (Synthesis of p-toluenesulfonylmethacrylamide)

In a 1 liter four-necked flask equipped with a thermometer, a condenser tube, a stirrer and a dropping tube, 171.0 g (1.0 mol) of p-toluenesulfonamide and 700 ml of tetrahydrofuran were charged. Under ice cooling, 94.1 g (0.9 mol) of methacrylic acid chloride was added dropwise over one hour. After the completion of dropwise addition, the reaction temperature was returned to room temperature, followed by continuous stirring for 30 minutes and further stirring at 60°C for one hour. After the completion of the reaction, the reaction solution was poured into 3 liter of water thereby to precipitate the reaction product. The precipitate was washed with water and dried at 30°C under reduced pressure to obtain 154.9 g of p-toluenesulfonylmethacrylamide (yield: 72%).

### (Synthesis of 2-(N'-(4-hydroxyphenyl)ureylene)ethylmethacrylate)

In a 1 liter four-necked flask equipped with a thermometer, a condenser tube, a stirrer and a dropping tube, 500 g of dimethylacetamide and 173.5 g (1.6 mol) of p-aminophenol were charged. Under ice cooling, 234.9 g (1.5 mol) of 2-methacryloyloxyethyl isocyanate (manufactured by SHOWA DENKO K.K. under the trade name of Karenz MOI) was added dropwise over one hour. After the completion of the reaction, the reaction temperature was returned to room temperature, followed by continuous stirring for 5 hours. IR spectrum was measured and it was confirmed that adsorption of isocyanate was minimized. Then, 30 ml of concentrated hydrochloric acid was added to the reaction solution, followed by stirring for 15 minutes. The reaction solution was poured into 4.5 liter of water thereby to precipitate the reaction product. The precipitate was filtered, washed with water and then dried at 30°C under reduced pressure to obtain. 370 g 2-(N'-(4-hydroxyphenyl)ureylene)ethylmethacrylate (yield: 93.4%)

### (Synthesis of binder D2)

In a 300 ml three-necked flask equipped with a capacitor and a stirrer, 100.00 g of dimethylacetamide was charged and, after the atmosphere in the flask was replaced by nitrogen, the liquid temperature was raised to 80°C. To this was added, dropwise, a solution prepared by dissolving 13.00 g of allyl methacrylate, 3.50 g of p-toluenesulfonylmethacrylamide, 3.50 g of 2-(N'-(4-hydroxyphenyl)ureylene)ethylmethacrylate and 0.40 g of 2,2'-azobisisobutyronitrile in 80.00 g of dimethylacetamide over 2 hours. One hour after the completion of dropwise addition, 0.20 g of 2,2'-azobisisobutyronitrile was added again, followed by heating for 5 hours. The reaction solution was poured into 1 liter of water while stirring thereby to precipitate a yellowish white polymer. The polymer was washed with water and vacuum dried to obtain 18.00 g of a binder resin D2 of the following formula. Yield was 90% by weight.

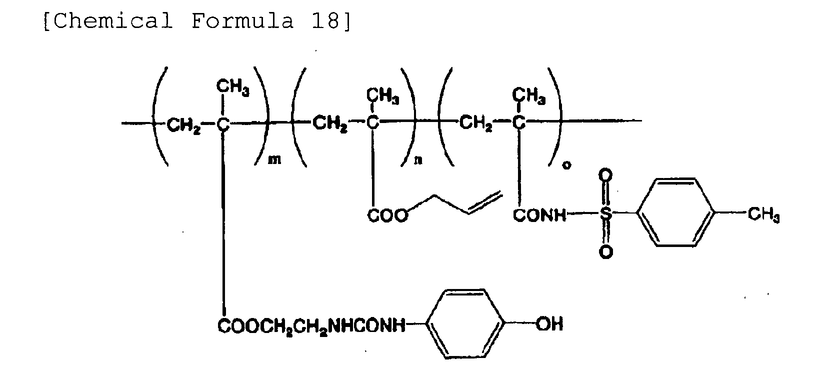

### [Example 1]

As is apparent from the formulation shown in Table 1, a coating solution of a negative working photosensitive composition was prepared by dissolving 0.2 g (2% by weight) of a near infrared absorbing cationic dye (A) (manufactured by Showa Denko K.K. under the trade name of IRT) represented by the following formula (A) as the infrared absorber (A), 0.6 g (0.6% by weight) of an organic boron compound (B1) (manufactured by Showa Denko K.K. under the trade name of P3B) represented by the following formula (B1) as the organic boron compound (B), 0.9 g (9% by weight) of an onium salt (C) (manufactured by Wako Pure Chemicals Industries, Ltd.) represented by the above [Chemical Formula 15] as the onium salt, 3.0 g (30% by weight) of dipentaerythritol hexaacrylate (manufactured by Nippon Kayaku Co., Ltd.) as the compound having a polymerizable unsaturated group (C), 4.8 g (48% by weight) of the binder resin (D1) as the binder resin (D), 0.2 g of DC-190 (10%, ethylene glycol monomethyl ether solution, manufactured by Eastman Kodak Company) as the surfactant and 0.3 g of Crystal Violet (manufactured by Hodogaya Chemical Co., LTD.) as the colorant in a solvent mixture of 70.0 g of ethylene glycol monomethyl ether and 20.0 g of methyl ethyl ketone.

A 0.30 mm thick aluminum plate was degreased with an aqueous sodium hydroxide solution and then subjected to an electrolytic polishing treatment in a 2% hydrochloric acid bath to obtain a grained plate having a center line average roughness (Ra) of 0.55 µm. This grained plate was anodized in a 20% sulfuric acid bath at a current density of 2 A/dm² to form an oxide film (2.6 g/m²), passed through an aqueous 2.5% sodium silicate solution at 70°C for 30 seconds, washed with water and then dried to obtain an aluminum substrate. A coating solution of the above negative working photosensitive composition was applied on the aluminum substrate using a roll coater and then dried at 110°C for 30 seconds to obtain a negative working photosensitive lithographic printing plate. The dry coating weight was 2.0 g/m².

The photosensitive lithographic printing plate immediately after the production was imagewise exposed by an exposure apparatus equipped with a near infrared semiconductor laser (Trendsetter 3244, manufactured by CREO Co., wavelength: 830 nm, laser output: 10 W, rotation speed: 150 rpm). After exposure, the photosensitive lithographic printing plate was developed with a developing solution (solution mixture of 700 parts by volume of water, 40 parts by volume of a surfactant PELEX NBL manufactured by Kao Corporation and 14 parts by volume of potassium silicate) at 30°C for 15 seconds using an automatic processor (manufactured by FUJI PHOTO FILM CO., LTD. under the trade name of PS-900N). The sensitivity and the printing durability of the resulting lithographic printing plate were evaluated. The results are shown in Table 2.

### (Image)

With respect to dots of the lithographic printing plate after subjecting to the developing treatment, reproducibility was confirmed and evaluated. In Table 2, the symbol A indicates good reproducibility of dots, and reproducibility of dots deteriorates in order of the symbols B, C, D and E.

### (Storage stability)

With respect to storage stability, the photosensitive lithographic printing plate was stored under the conditions of 38°C and 80%RH for one week and then any change in developing properties was confirmed and evaluated. In Table 2, the symbol A indicates excellent storage stability, and storage stability deteriorates in order of the symbols B, C, D and E.

### [Examples 2 to 5, Comparative Examples 1 to 2]

In the same manner as in Example 1, except that the formulation of the coating solution was replaced by the formulation shown in Table 1, negative working photosensitive lithographic printing plates were produced and evaluated. The evaluation results are shown in Table 2. An organic boron compound (B2) in Table 1 is represented by the following formula (B2) (manufactured by Showa Denko K.K. under the trade name of NP3B), an onium salt (2) is represented by the following formula (2) (manufactured by Wako Pure Chemicals Industries, Ltd.), and an onium salt (3) is represented by the following formula (3) (manufactured by Wako Pure Chemicals Industries, Ltd.).

**[Table 1]**

| Components | Examples | | | | | Comparative Examples | |
|---|---|---|---|---|---|---|---|
| | 1 | 2 | 3 | 4 | 5 | 1 | 2 |
| Binder resin (D1) | 4.8 | | 4.8 | 4.8 | 4.8 | | 4.8 |
| Binder resin (D2) | | 4.8 | | | | | |
| Copolymer of allyl methacrylate/methacrylic acid | | | | | | 4.8 | |
| Onium salt (1) | 0.9 | 0.9 | | | 0.9 | 0.9 | 0.9 |
| Onium salt (2) | | | 0.9 | 0.45 | | | |
| Onium salt (3) | | | | 0.45 | | | |
| Dipentaerythritol hexaacrylate (C) | 3.0 | 3.0 | 3.0 | 3.0 | 3.0 | 3.0 | 3.0 |
| Organic boron compound (B1) | 0.6 | 0.6 | 0.6 | 0.6 | | 0.6 | |
| Organic boron compound (B2) | | | | | 0.6 | | |
| Infrared absorber (A) | 0.2 | 0.2 | 0.2 | 0.2 | 0.2 | 0.2 | 0.2 |
| DC-190 (30% MEK) | 0.2 | 0.2 | 0.2 | 0.2 | 0.2 | 0.2 | 0.2 |
| Crystal Violet | 0.3 | 0.3 | 0.3 | 0.3 | 0.3 | 0.3 | 0.3 |
| Ethylene glycol monomethyl ether | 70.0 | 70.0 | 70.0 | 70.0 | 70.0 | 70.0 | 70.0 |
| Methyl ethyl ketone | 20.0 | 20.0 | 20.0 | 20.0 | 20.0 | 20.0 | 20.0 |

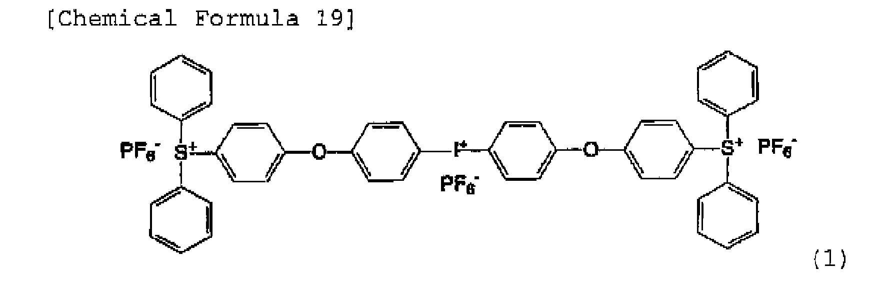

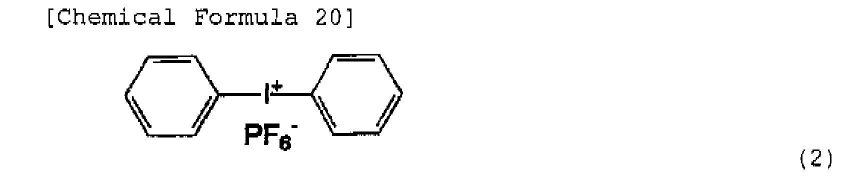

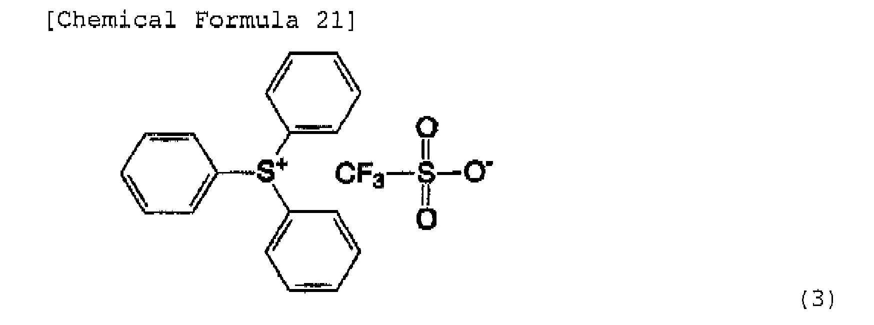

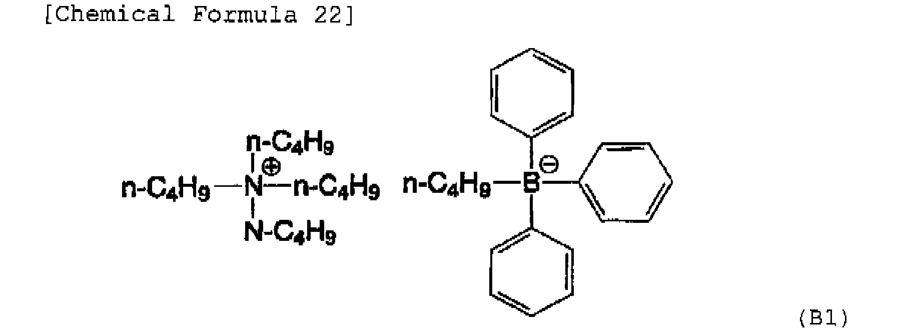

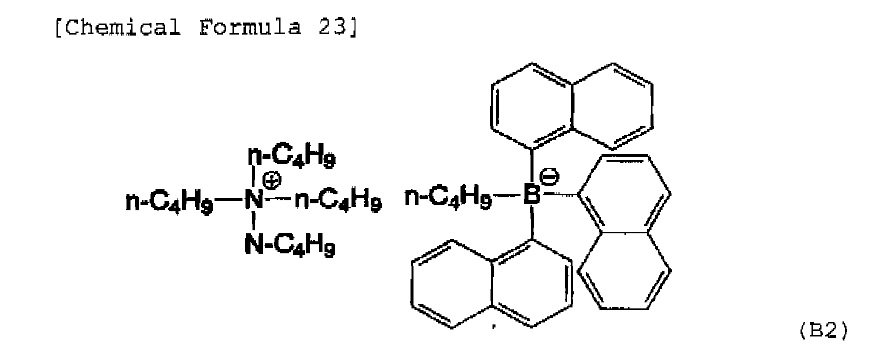

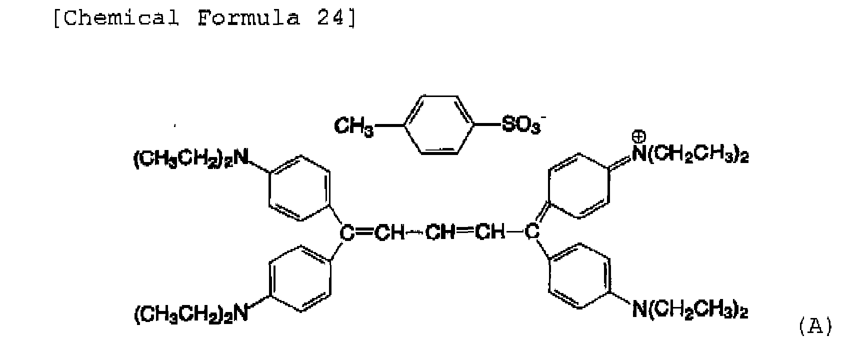

**[Table 2]**

| Evaluation results | Examples | | | | | Comparative Examples | |
|---|---|---|---|---|---|---|---|
| | 1 | 2 | 3 | 4 | 5 | 1 | 2 |
| Image | A | B | A | A | B | A | E impossible to form images |
| Storage stability | A | A | A | A | A | E | - |

As is apparent from the results shown in Table 2, the negative working photosensitive lithographic printing plates of Examples 1 to 5 showed high sensitivity and were excellent in storage stability. In case of the negative working photosensitive lithographic printing plate containing no binder resin having a sulfonamide or

**[Table 1]**

| Components | Examples | | | | | Comparative Examples | |
|---|---|---|---|---|---|---|---|
| | 1 | 2 | 3 | 4 | 5 | 1 | 2 |
| Binder resin (D1) | 4.8 | | 4.8 | 4.8 | 4.8 | | 4.8 |
| Binder resin (D2) | | 4.8 | | | | | |
| Copolymer of allyl methacrylate/methacrylic acid | | | | | | 4.8 | |
| Onium salt (1) | 0.9 | 0.9 | | | 0.9 | 0.9 | 0.9 |
| Onium salt (2) | | | 0.9 | 0.45 | | | |
| Onium salt (3) | | | | 0.45 | | | |
| Dipentaerythritol hexaacrylate (C) | 3.0 | 3.0 | 3.0 | 3.0 | 3.0 | 3.0 | 3.0 |
| Organic boron compound (B1) | 0.6 | 0.6 | 0.6 | 0.6 | | 0.6 | |
| Organic boron compound (B2) | | | | | 0.6 | | |
| Infrared absorber (A) | 0.2 | 0.2 | 0.2 | 0.2 | 0.2 | 0.2 | 0.2 |
| DC-190 (30% MEK) | 0.2 | 0.2 | 0.2 | 0.2 | 0.2 | 0.2 | 0.2 |
| Crystal Violet | 0.3 | 0.3 | 0.3 | 0.3 | 0.3 | 0.3 | 0.3 |
| Ethylene glycol monomethyl ether | 70.0 | 70.0 | 70.0 | 70.0 | 70.0 | 70.0 | 70.0 |
| Methyl ethyl ketone | 20.0 | 20.0 | 20.0 | 20.0 | 20.0 | 20.0 | 20.0 |

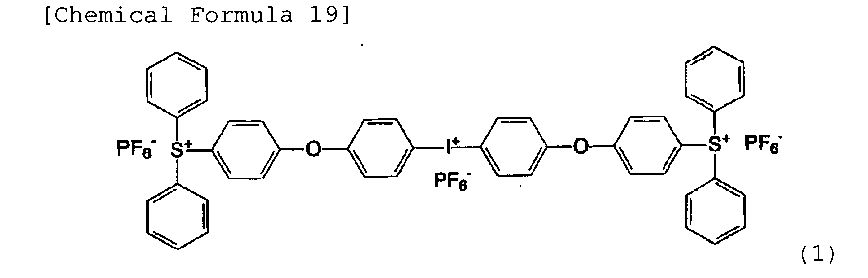

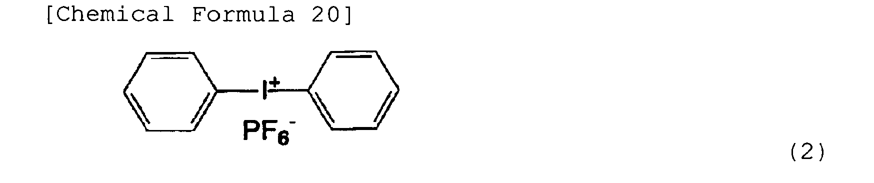

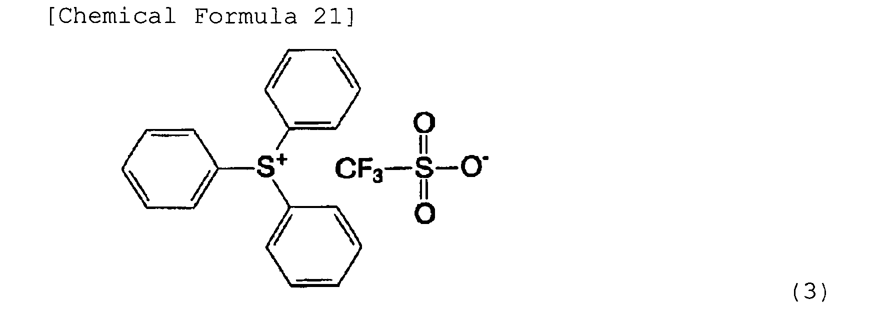

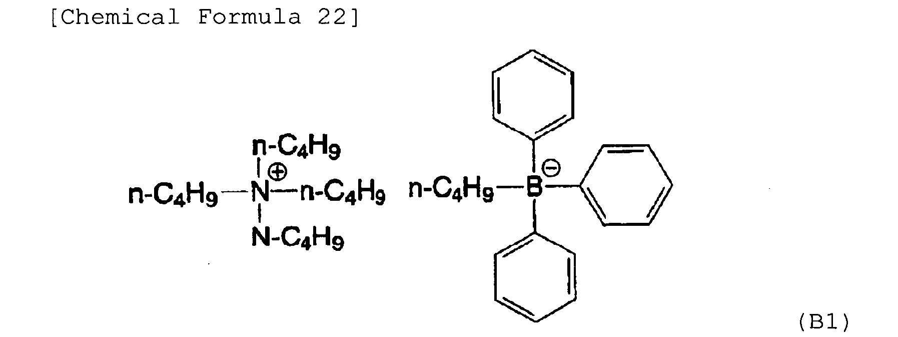

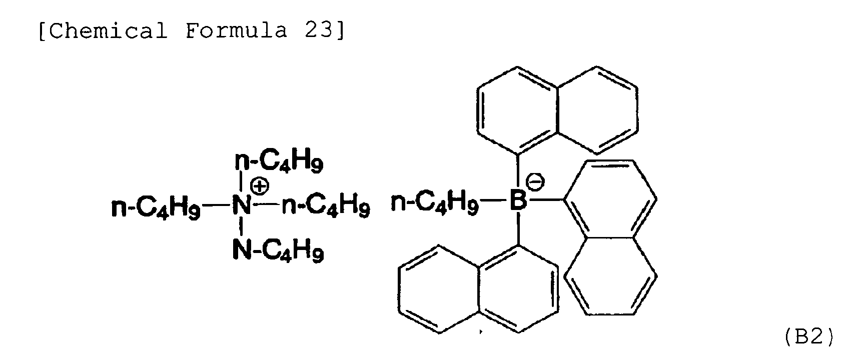

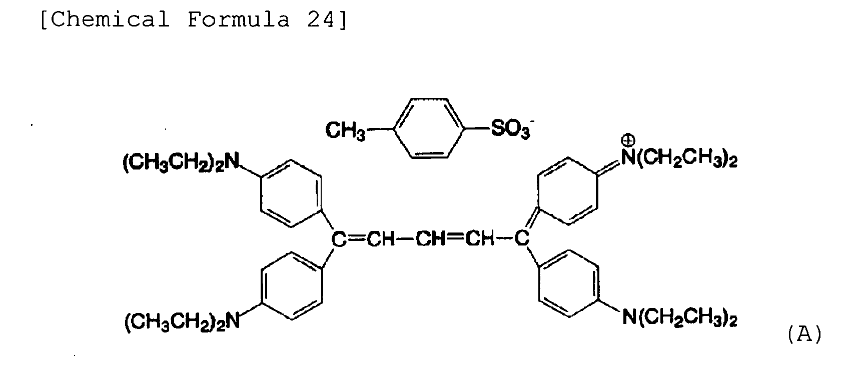

**[Table 2]**

| Evaluation results | Examples | | | | | Comparative Examples | |
|---|---|---|---|---|---|---|---|
| | 1 | 2 | 3 | 4 | 5 | 1 | 2 |
| Image | A | B | A | A | B | A | E impossible to form images |
| Storage stability | A | A | A | A | A | E | - |

As is apparent from the results shown in Table 2, the negative working photosensitive lithographic printing plates of Examples 1 to 5 showed high sensitivity and were excellent in storage stability. In case of the negative working photosensitive lithographic printing plate containing no binder resin having a sulfonamide or active imino group (D) of Comparative Example 1 and the negative working photosensitive lithographic printing plate containing no organic boron compound (B) of Comparative Example 2, storage stability was poor and also images could not be formed and the storage stability could not be evaluated.

## Claims

1. A negative working photosensitive composition comprising:
(A) an infrared absorber,
(B) an organic boron compound,
(C) a compound having a polymerizable unsaturated group, and
(D) a binder resin having a sulfonamide or active imino group.

2. The negative working photosensitive composition according to claim 1, wherein the binder resin has a phenolic hydroxyl group.

3. The negative working photosensitive composition according to claim 1, wherein the binder resin has a polymerizable unsaturated group.

4. The negative working photosensitive composition according to claim 2, wherein the binder resin has a polymerizable unsaturated group.

5. The negative working photosensitive composition according to claim 1, wherein the infrared absorber is a near-infrared absorbing cationic dye represented by the following formula (1):
D⁺A⁻ (1)
wherein D⁺ represents a cationic dye having an absorption in a near-infrared range, and A⁻ represents an anion.

6. The negative working photosensitive composition according to claim 2, wherein the infrared absorber is a near-infrared absorbing cationic dye represented by the following formula (1):
D⁺A⁻ (1)
wherein D⁺ represents a cationic dye having an absorption in a near-infrared range, and A⁻ represents an anion.

7. The negative working photosensitive composition according to claim 3, wherein the infrared absorber is a near-infrared absorbing cationic dye represented by the following formula (1):
D⁺A⁻ (1)
wherein D⁺ represents a cationic dye having an absorption in a near infrared range, and A⁻ represents an anion.

8. The negative working photosensitive composition according to claim 1, wherein the organic boron compound is an ammonium salt of a quaternary boron anion represented by the following formula (2): 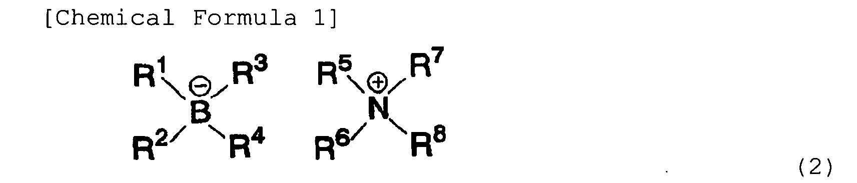 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

9. The negative working photosensitive composition according to claim 2, wherein the organic boron compound is an ammonium salt of a quaternary boron anion represented by the following formula (2): 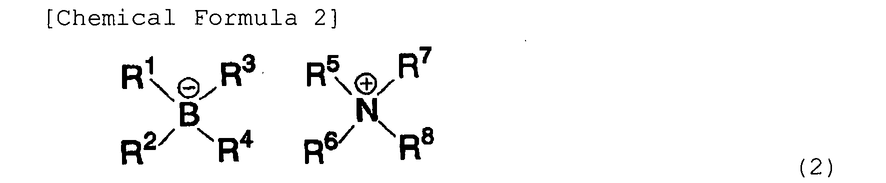 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

10. The negative working photosensitive composition according to claim 3, wherein the organic boron compound is an ammonium salt of a quaternary boron anion represented by the following formula (2): 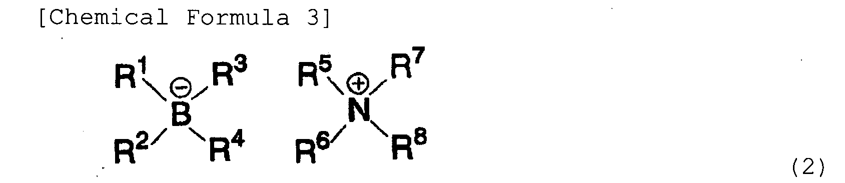 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

11. The negative working photosensitive composition according to claim 5, wherein the organic boron compound is an ammonium salt of a quaternary boron anion represented by the following formula (2): 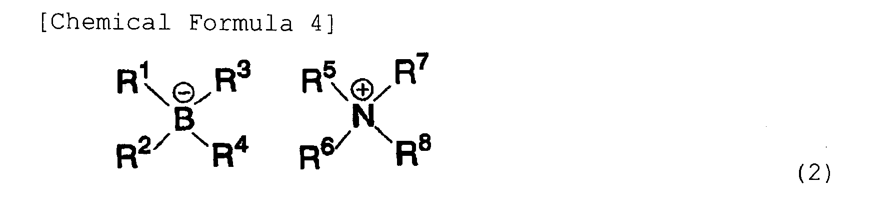 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

12. The negative working photosensitive composition according to claim 6, wherein the organic boron compound is an ammonium salt of a quaternary boron anion represented by the following formula (2): 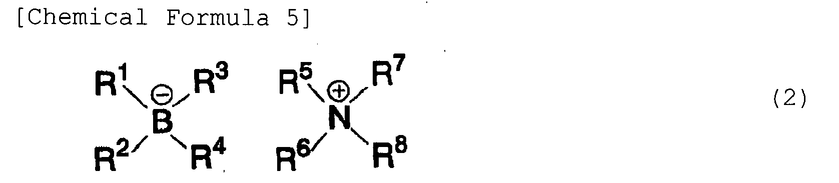 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

13. The negative working photosensitive composition according to claim 7, wherein the organic boron compound is an ammonium salt of a quaternary boron anion represented by the following formula (2): 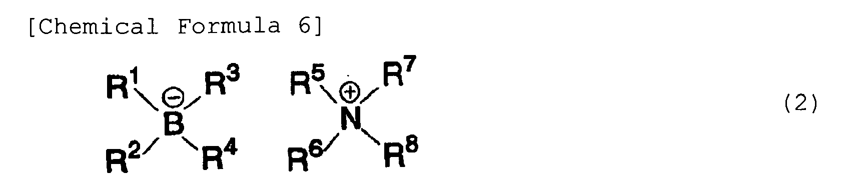 wherein R¹, R², R³ and R⁴ each independently represents an alkyl group, an aryl group, an alkaryl group, an allyl group, an aralkyl group, an alkenyl group, an alkynyl group, an alicyclic group, or a saturated or unsaturated heterocyclic group, at least one of R¹, R², R³ and R⁴ is an alkyl group having 1 to 8 carbon atoms, and R⁵, R⁶, R⁷ and R⁸ each independently represents a hydrogen atom, an alkyl group, an aryl group, an allyl group, an alkaryl group, an aralkyl group, an alkenyl group, an alkynyl group, an alicyclic group, or a saturated or unsaturated heterocyclic group.

14. A negative working photosensitive lithographic printing plate comprising a substrate and a photosensitive layer, containing the negative working photosensitive composition according to any one of claims 1 to 13, formed on the substrate.
